# EUROPEAN PATENT APPLICATION

(11) **EP 4 318 872 A1**
(43) Date of publication of application: **07.02.2024**
(21) Application number: 22804641.3
(22) Date of filing: 16.05.2022
(51) Int. Cl.: H02J 50/12, H02J 50/40, H02J 50/80

(54) **WIRELESS POWER FEEDING SYSTEM AND METHOD, AND WIRELESS POWER TRANSMISSION SYSTEM**

(30) Priority: 17.05.2021 JP 2021083509; 28.01.2022 JP 2022012446; 28.01.2022 JP 2022012447
(71) Applicant: LAUREL BANK MACHINES CO., LTD., Tokyo 105-8414 (JP); Laurel Machinery Co., Ltd., Osaka-shi, Osaka, 542-0086 (JP); Laurel Precision Machines Co., Ltd., Osaka-shi, Osaka 542-0086 (JP); Tokyo Institute of Technology, Tokyo 152-8550 (JP)
(72) Inventor: NAKANISHI, Hideyuki, Tokyo 105-8414 (JP); OHORI, Toshiki, Tokyo 152-8550 (JP); HIJIKATA, Wataru, Tokyo 152-8550 (JP); LI, Xiang, Tokyo 105-8414 (JP); OZAWA, Shigeki, Tokyo 105-8414 (JP)
(74) Representative: Schäfer, Matthias W.
(86) International application number: PCT/JP2022/020380
(87) International publication number: WO 2022/244730

(57) **Abstract**

To provide a wireless power feeding system and method and a wireless power transmission system, in which a decrease in power transmission efficiency is reduced even when an impedance of a load-side circuit varies. A wireless power feeding system 1 that transmits and receives power using magnetism includes a power transmission device 3 that includes a power transmission-side resonance circuit 36 including a power transmission coil 32 and a power feeding coil 31 that is provided to be capable of magnetic field coupling to the power transmission coil 32 and transmits power to be fed from its input end IE to the power transmission coil 32, and a power reception device 4 that includes a power reception-side resonance circuit 43 including a power reception coil 41 and feeds power received by the power reception coil 41 to a load 8, and an impedance matching mechanism 9 that performs impedance matching processing for alleviating a difference between a load-side impedance as an impedance of a circuit on a load 8 side from the input end IE of the power transmission device 3 and an input-side impedance as an impedance of a circuit on an AC power supply 5 side from the input end IE of the power transmission device 3 by changing a coupling strength in magnetic-field coupling between the power feeding coil 31 and the power transmission coil 32.

## Description

### Technical Field

The present invention relates to a wireless power feeding system and method and a wireless power transmission system.

### Background Art

In recent years, a wireless power feeding system using a magnetic field has been researched and developed. There have been known as such a power feeding method using magnetism an electromagnetic coupling (electromagnetic induction) method and a magnetic field resonance method. A magnetic field resonance method means transmitting power via a state (magnetic field resonance coupling) where oscillation of a magnetic field generated by an AC current flowing through a resonance circuit in a power transmission device is transmitted to a resonance circuit in a power reception device to resonate so that magnetic fields respectively generated by coils of the resonance circuits are firmly coupled to each other. Wireless power feeding using the magnetic field resonance method has an advantage that a power feedable distance becomes longer than that in wireless power feeding using the electromagnetic coupling method (see, e.g., Patent Literature 1). Although the magnetic field resonance method is a method using magnetic coupling, a method using resonance is a magnetic field resonance method to make understanding easy in the present invention.

In such a wireless power feeding system, an impedance of a load-side circuit including a power reception device and a load or the like viewed from a power transmission device and an impedance on the power supply side viewed from a power transmission device need to be equivalently set to efficiently transmit power.

### Citation List

### Patent Literature

Patent Literature 1: Japanese Patent Laid-Open No. 2018-505369

### Summary of Invention

### Technical Problem

However, a driving member such as a battery or a motor is connected to the above-described load-side circuit, and the battery or the motor is a load. Accordingly, a current flowing through the load-side circuit may vary depending on a driving state of the battery or the motor. In the wireless power feeding system, an impedance of the load-side circuit varies depending on the variation of the current flowing through the load-side circuit. Accordingly, an impedance of the load-side circuit as viewed from the power transmission device and an impedance on a power supply side as viewed from the power transmission device do not match each other. Accordingly, a transmission efficiency substantially decreases so that transmission power decreases. As a result, there has been a problem that a system failure may occur.

There occurs a technical problem to be solved to reduce a decrease in transmission efficiency even when an impedance of a load-side circuit varies, and the present invention has its object to solve this problem.

### Solution to Problem

To attain the above-described object, a wireless power feeding system according to the present invention is a wireless power feeding system that transmits and receives power using magnetism, the wireless power feeding system including a power transmission device that includes a power transmission-side resonance circuit including a power transmission coil and a power feeding coil that is provided to be capable of magnetic field coupling to the power transmission coil and transmits power to be fed from its input end to the power transmission coil, a power reception device that includes a power reception-side resonance circuit including a power reception coil and feeds power received by the power reception coil, and an impedance matching mechanism that performs impedance matching processing for alleviating a difference between a load-side impedance as an impedance of a circuit on a load side from the input end of the power transmission device and an input-side impedance as an impedance of a circuit on a power supply device side from the input end of the power transmission device by changing a coupling strength in magnetic field coupling between the power feeding coil and the power transmission coil.

To attain the above-described object, a wireless power feeding method according to the present invention is a wireless power feeding method using a wireless power feeding system that transmits and receives power using magnetism and includes a power transmission device that includes a power transmission-side resonance circuit including a power transmission coil and a power feeding coil that is provided to be capable of magnetic field coupling to the power transmission coil and transmits power to be fed from its input end to the power transmission coil, and a power reception device that includes a power reception-side resonance circuit including a power reception coil and feeds power received by the power reception coil to a load, the wireless power feeding method including alleviating a difference between a load-side impedance as an impedance of a circuit on a load side from the input end of the power transmission device and an input-side impedance as an impedance of a circuit on a power supply device side from the input end of the power transmission device by changing a coupling strength in magnetic field coupling between the power feeding coil and the power transmission coil using an impedance matching mechanism.

To attain the above-described object, a wireless power transmission system according to the present invention is a wireless power transmission system that transmits power to a power reception device using magnetism, the wireless power transmission system including a power transmission device that includes a power transmission-side resonance circuit including a power transmission coil and a power feeding coil that is provided to be capable of magnetic field coupling to the power transmission coil and transmits power to be fed from its input end to the power transmission coil and that transmits the power to a load via the power reception device, and an impedance matching mechanism that performs impedance matching processing for alleviating a difference between a load-side impedance as an impedance of a circuit on a load side from the input end of the power transmission device and an input-side impedance as an impedance of a circuit on a power supply device side from the input end of the power transmission device by changing a coupling strength in magnetic field coupling between the power feeding coil and the power transmission coil.

### Advantageous Effect of Invention

According to the present invention, even when an impedance of a load-side circuit varies, a difference between an input-side impedance and a load-side impedance is alleviated, whereby a reflected wave is prevented from being generated at an input end, thereby making it possible to avoid a decrease in transmission efficiency and a system failure caused thereby.

### Brief Description of Drawings

[Figure 1] Figure 1 is a schematic view illustrating a configuration of a wireless power feeding system according to a first embodiment of the present invention.
[Figure 2] Figure 2 is a schematic view illustrating a configuration of an impedance matching mechanism.
[Figure 3] Figure 3 is a circuit diagram corresponding to the wireless power feeding system.
[Figure 4] Figure 4 is an equivalent circuit diagram corresponding to the circuit diagram illustrated in Figure 3.
[Figure 5] Figure 5 is a graph illustrating a relationship between a load voltage and a load current.
[Figure 6] Figure 6 is a graph illustrating a relationship between a load current and a load-side impedance.
[Figure 7] Figure 7 is a schematic view illustrating a positional relationship between a power transmission coil and three power feeding coil parts arranged by being respectively offset in axial directions of their coil axes.
[Figure 8] Figure 8 is a graph illustrating a relationship between a distance from a power feeding coil to a power transmission coil and a load resistance.
[Figure 9] Figure 9 is a schematic view illustrating how a coil movement mechanism slides a power feeding coil in a direction perpendicular to its coil axis.
[Figure 10] Figure 10 is a schematic view illustrating how a coil movement mechanism slides a power feeding coil parallel to its coil axis.
[Figure 11] Figure 11 is a schematic view illustrating a positional relationship between a power transmission coil and three power feeding coil parts arranged by being respectively offset in directions perpendicular to axial directions of their coil axes.
[Figure 12] Figure 12 is a schematic view illustrating a positional relationship between a power transmission coil and eight power feeding coil parts inclined with respect to the power transmission coil and arranged in a substantially spherical shape.
[Figure 13] Figure 13 is a schematic view illustrating a positional relationship between a power transmission coil and three power feeding coil parts constituting a power feeding coil formed in a spherical shape.
[Figure 14] Figure 14 is a schematic view illustrating a positional relationship between a power transmission coil and three power feeding coil parts arranged on the same plane.
[Figure 15] Figure 15 is a schematic view illustrating a configuration of an impedance matching mechanism to be applied to a wireless power feeding system according to a second embodiment of the present invention.
[Figure 16] Figure 16 is a schematic view illustrating how a coil movement mechanism to be applied to a wireless power feeding system according to a third embodiment of the present invention moves a power feeding coil in a direction perpendicular to its coil axis.
[Figure 17] Figure 17 is a schematic view illustrating how a coil movement mechanism to be applied to the wireless power feeding system according to the third embodiment of the present invention swings a power feeding coil.

### Description of Embodiment

### <First Embodiment>

A wireless power feeding system 1 according to a first embodiment of the preset invention and a wireless power feeding method using the wireless power feeding system 1 will be described with reference to the drawings. Hereinafter, when reference is made to the number of components or a numerical value, amount, range, or the like of each of the components, the number or the like is not limited to a particular number but may be the particular number or more or the particular number or less unless otherwise stated or except when expressly limited to the particular number in principle.

When reference to a shape of each of components and a positional relationship among the components, a substantially approximate or similar shape or the like is included unless otherwise stated or except when considered to be expressly excluded in principle.

In the drawings, there is a case where characteristic portions are exaggerated by being enlarged, for example, in order to facilitate the understanding of features, and a dimension ratio or the like of each of the components is not necessarily the same as an actual one. In a cross-sectional view, hatching of some of the components may be omitted in order to facilitate the understanding of a cross-sectional structure of the components.

### <Configuration of Wireless Power Feeding System>

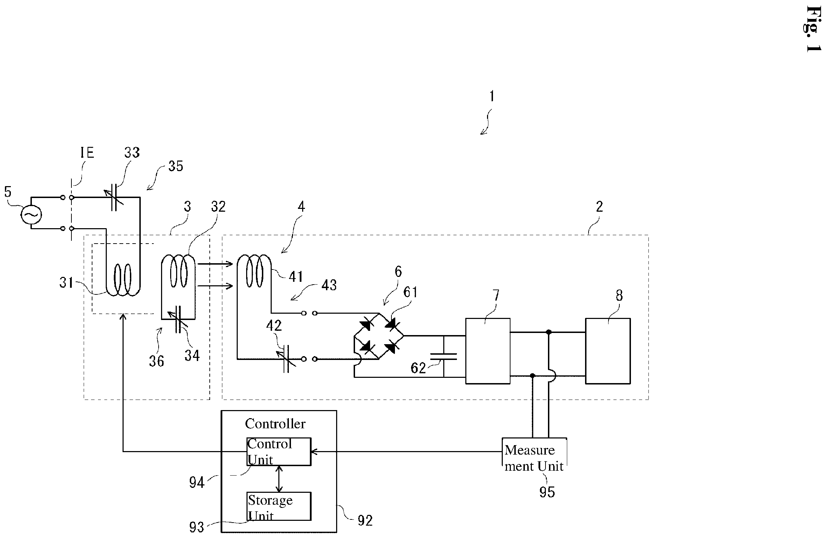

Figure 1 is a schematic view illustrating a configuration of a wireless power feeding system 1. The wireless power feeding system 1 feeds power to a power feeding target 2 in a non-contact manner using magnetic field resonance. The power feeding target 2 is a vehicle, a robot flying object, an underwater robot, a capsule endoscope, or a cardiac pacemaker, for example, and may be either one of movable equipment and immovable equipment. During power feeding, the power feeding target 2 may be either moving or stopped. The wireless power feeding system 1 includes a power transmission device 3 and a power reception device 4.

### <Configuration of Power Transmission Device>

The power transmission device 3 includes a power feeding coil 31, a power transmission coil 32, and capacitors 33 and 34.

The power feeding coil 31 and the power transmission coil 32 are formed by winding a copper wire or the like having a high electrical conductivity in a circular shape. A larger amount of current flows through the copper wire in the vicinity of a surface of the copper wire than in a central portion of the copper wire due to an influence of an internal resistance. Therefore, when a litz wire obtained by twisting a plurality of copper wires together is used as each of wires of the power feeding coil 31 and the power transmission coil 32, the surface area of the litz wire is larger than that of one of the copper wires having the same diameter so that a larger amount of current can flow, thereby making it possible to suppress a current loss.

AC power is fed from an AC power supply 5 to the power feeding coil 31. Although the AC power is set to a frequency of 150 kHz and a voltage of 10 V, for example, a frequency and a voltage of the AC power supply 5 can be arbitrarily changed. Hereinafter, a contact on the AC power supply 5 side of the power feeding coil 31 is referred to as an "input end IE". Although a case where the power feeding coil 31 and the AC power supply 5 are directly connected to each other via the input end IE is described as an example in the present embodiment, the power feeding coil 31 and the AC power supply 5 may be directly connected to each other via the input end IE or may be indirectly connected to each other via a coaxial cable or the like provided between the AC power supply 5 and the input end IE. In this case, if an impedance of the power supply matches an impedance of the coaxial cable or the like, no power reflection or the like occurs at a power supply-side end of the coaxial cable or the like, causing no problem, and the input end IE means a load-side end of the coaxial cable or the like.

The power feeding coil 31 and the capacitor 33 are connected in series, to constitute a power feeding-side resonance circuit 35. When an AC voltage having a frequency corresponding to a resonance frequency set by an inductance of the power feeding coil 31 and a capacitance of the capacitor 33 flows through the power feeding coil 31, an oscillating magnetic field occurs to penetrate the power feeding coil 31. A specific configuration of the power feeding coil 31 will be described below.

The power feeding coil 31 and the power transmission coil 32 are magnetically coupled to each other, and the power feeding coil 31 feeds power to the power transmission coil 32 using a magnetic field resonance method. That is, a resonance frequency set depending on the impedance of the power feeding coil 31 and the capacitance of the capacitor 33 and a resonance frequency set depending on an inductance of the power transmission coil 32 and a capacitance of the capacitor 34 are substantially equal to each other, and the power feeding coil 31 and the power transmission coil 32 are designed to resonate. As a result, when oscillation of a magnetic field having a specific frequency (resonance frequency) generated by an AC current flowing through the power feeding coil 31 is transmitted to the power transmission coil 32 so that the power transmission coil 32 resonates at the same specific frequency, an electromotive force occurs in the power transmission coil 32. Although a magnetic field resonance method in which an influence of a positional relationship between the power feeding coil 31 and the power transmission coil 32 is reduced is favorably used to feed power from the power feeding coil 31 to the power transmission coil 32, an electromagnetic coupling method in which an electromotive force also occurs in the power transmission coil 32 via a magnetic flux occurring to penetrate the power feeding coil 31 in a coil axial direction when an AC current flows through the power feeding coil 31 may be used. The magnetic field resonance method and the electromagnetic coupling method may be used in combination.

The power transmission coil 32 and the capacitor 34 are connected in series, to constitute a power transmission-side resonance circuit 36. When an AC voltage having a frequency corresponding to the resonance frequency set by the inductance of the power transmission coil 32 and the capacitance of the capacitor 33 flows through the power transmission coil 32, a power reception coil 41, described below, resonates so that an electromotive force occurs.

### <Configuration of Power Reception Device>

The power reception device 4 is provided in the power feeding target 2. The power reception device 4 includes the power reception coil 41 and a capacitor 42.

The power reception device 41 is provided to be spaced away from the power transmission coil 32 in the coil axial direction. The power reception coil 41 is formed by winding a copper wire or the like having a high electrical conductivity in a circular shape. The power reception coil 41 also preferably uses a litz wire as a wire, like the power feeding coil 31 and the power transmission coil 32.

The power reception coil 41 and the capacitor 42 are connected in series, to constitute a power reception-side resonance circuit 43. A resonance frequency set by an inductance of the power reception coil 41 and a capacitance of the capacitor 42 is set to substantially match the respective resonance frequencies of the power transmission coil 32 and the capacitor 33. As a result, an induced current flows through the power reception coil 41 due to oscillation of a magnetic field that has occurred to penetrate the power transmission coil 32 in the coil axial direction, and an oscillating magnetic field occurs to penetrate the power reception coil 41 in the coil axial direction. At this time, respective magnetic fields in the power transmission coil 32 and the power reception coil 41 resonate, to be firmly coupled to each other.

AC power resonantly received by the power reception coil 41 is fed to a load 8 via a rectifying circuit (AC-DC converter) 6 and a DC-DC converter 7. The load 8 is a motor, a battery, or the like constituting the power feeding target 2.

The rectifying circuit 6 has four diodes 61 arranged on its bridge, to full-wave rectify the AC power received by the power reception coil 41 and output a DC voltage. Reference numeral 62 denotes a capacitor that smooths the DC voltage outputted by the rectifying circuit 6.

The DC-DC converter 7 converts the rectified DC voltage into a constant voltage (e.g., 12 V) previously set. The voltage outputted from the DC-DC converter 7 is applied to the load 8. The DC-DC converter 7 may be arranged depending on a required voltage, or may be appropriately omitted.

### <Configuration of Impedance Matching Mechanism>

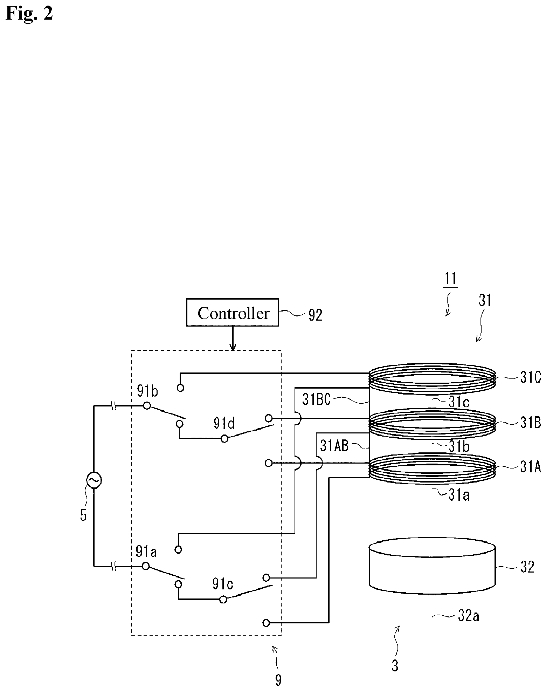

Then, an impedance matching mechanism 9 that performs impedance matching processing for alleviating a difference between an impedance (hereinafter referred to as a "load-side impedance") of a circuit (load-side circuit) on the power reception device 4 side from the input end IE, i.e., including the power transmission device 3, the power reception device 4, the rectifying circuit 6, the DC-DC converter 7, and the load 8 and an impedance (hereinafter referred to as an "input-side impedance") of a circuit on the AC power supply 5 side from the input end IE will be described with reference to Figure 2. The power transmission device 3 and the impedance matching mechanism 9 constitute a wireless power transmission system 11.

The impedance matching mechanism 9 feeds power to at least one of three power feeding coil parts 31A, 31B, and 31C constituting the power feeding coil 31 under switching control of switches 91a to 91d. If power can be selectively fed to any one of the power feeding coil parts 31A, 31B, and 31C, other components may be used instead of four switches 91a to 91d.

The power feeding coil 31 is divided into the three power feeding coil parts 31A, 31B, and 31C. The three power feeding coil parts 31A, 31B, and 31C are obtained by dividing the power feeding coil 31 into three and are connected substantially in series. The power feeding coil parts 31A and 31B are connected to each other via a wiring 31AB, and the power feeding coil parts 31B and 31C are connected to each other via a wiring 31BC. The wirings 31AB and 31BC may be omitted, as needed. Each of coil axes 31a, 31b, and 31c of the power feeding coil parts 31A, 31B, and 31C and a coil axis 32a of the power transmission coil 32 are positioned substantially coaxially with each other in a normal state. Although a case where the power feeding coil 31 is divided into the three power feeding coil parts 31A, 31B, and 31C will be described below as an example, the number of the power feeding coil parts may be two or four or more.

The power feeding coil parts 31A, 31B, and 31C are arranged such that the power feeding coil part 31A is closest to the power transmission coil 32 and such that they separate from the power transmission coil 32 in this order. Therefore, a coupling strength in magnetic field coupling to the power transmission coil 32 of the power feeding coil part 31A is set highest and a coupling strength in magnetic field coupling thereto of the power feeding coil part 31C is set lowest. When the power feeding coil 31 and the power transmission coil 32 are transmitted using a magnetic field resonance method, respective inductances of the power feeding coil parts 31A, 31B, and 31C are set equal to one another, thereby making it possible to efficiently transmit power.

Each of the switches 91a to 91d is a three-way switch for supplying a current to the power feeding coil parts 31A, 31B, and 31C. The switches 91a and 91b are connected to the AC power supply 5. The switch 91a is configured to be able to switch one end side of the power feeding coil part 31C and the switch 91c side. The switch 91c is configured to be able to switch one end side of the power feeding coil part 31A and one end side of the power feeding coil part 31B. The switch 91b is configured to be able to switch the other end side of the power feeding coil part 31C and the switch 91d side. The switch 91d is configured to be able to switch the other end side of the power feeding coil part 31A and the other end side of the power feeding coil part 31B.

When power is fed to the power feeding coil part 31A, the switch 91a is switched to the switch 91c side, the switch 91c is switched to the one end side of the power feeding coil part 31A, the switch 91b is switched to the switch 91d side, and the switch 91d is switched to the other end side of the power feeding coil part 31A. When power is fed to the power feeding coil part 31B, the switch 91a is switched to the switch 91c side, the switch 91c is switched to the one end side of the power feeding coil part 31B, the switch 91b is switched to the switch 91d side, and the switch 91d is switched to the other end side of the power feeding coil part 31B. Further, when power is fed to the power feeding coil part 31C, the switch 91a is switched to the power feeding coil part 31C, and the switch 91b is switched to the power feeding coil part 31C.

When power is fed to the power feeding coil parts 31A and 31B, the switch 91a is switched to the switch 91c side, the switch 91c is switched to the one end side of the power feeding coil part 31A, the switch 91b is switched to the switch 91d side, and the switch 91d is switched to the other end side of the power feeding coil part 31B. When power is fed to the power feeding coil parts 31B and 31C, the switch 91a is switched to the switch 91c side, the switch 91c is switched to the one end side of the power feeding coil part 31B, and the switch 91b is switched to the power feeding coil part 31C side.

Further, when power is fed to the power feeding coil parts 31A, 31B, and 31C, the switch 91a is switched to the switch 91c side, the switch 91c is switched to the one end side of the power feeding coil part 31A, and the switch 91b is switched to the power feeding coil part 31B side.

Switching control of the switches 91a to 91d is performed by a controller 92. The controller 92 includes a CPU, a memory, and the like, for example. A function of the controller 92 may be implemented by control using software, or may be implemented by operating using hardware. The function of the controller 92 is divided into a storage unit 93 and a control unit 94 (see Figure 1).

When power is fed to any one of the power feeding coil parts 31A, 31B, and 31C, the load-side impedance as the impedance of the circuit on the load side from the input end IE of the power transmission device 3 can be adjusted depending on a distance from the power transmission coil 32.

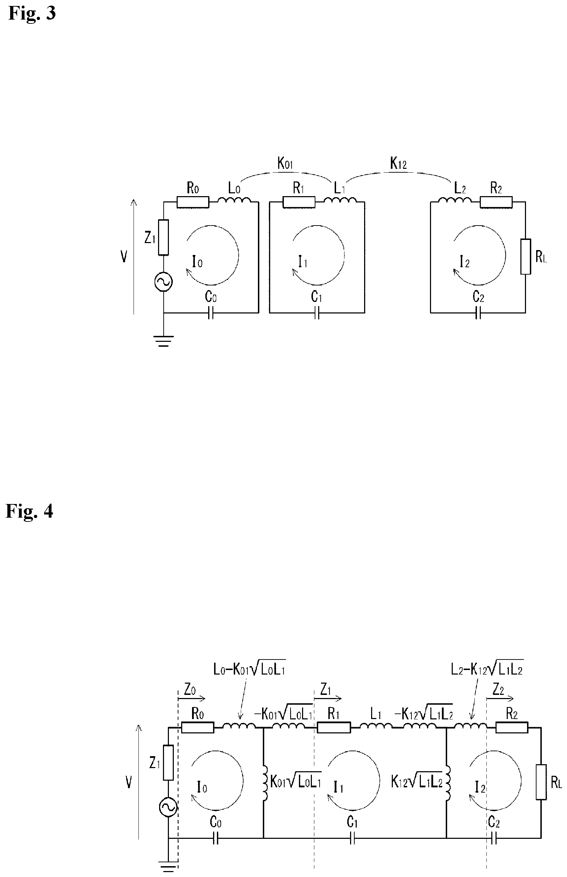

Specific description will be made with reference to Figures 3 and 4. Figure 3 is a circuit diagram corresponding to the wireless power feeding system 1. In Figure 3, "V" is a voltage of the power supply 5, "Zₛ" is an impedance (input-side impedance) of the power supply 5, "R₀" is a parasitic resistance of the power feeding coil 31, "L₀" is an inductance of the power feeding coil 31, "C₀" is a capacitance of the capacitor 33, "I₀" is a current flowing through the power feeding coil 31, "R₁" is a parasitic resistance of the power transmission coil 32, "L₁" is an inductance of the power transmission coil 32, "C₁" is a capacitance of the capacitor 34, "I₁" is a current flowing through the power transmission coil 32, "k₀₁" is a coupling coefficient between the power feeding coil 31 and the power transmission coil 32, "R₂" is a parasitic resistance of the power reception coil 41, "R_{L}" is a load resistance of the load 8, "L₂" is an inductance of the power reception coil 41, "C₂" is a capacitance of the capacitor 42, "I₂" is a current flowing through the power reception coil 41, and "k₁₂" is a coupling coefficient between the power transmission coil 32 and the power reception coil 41.

Figure 4 is an equivalent circuit diagram based on the circuit diagram illustrated in Figure 3. The equivalent circuit diagram illustrated in Figure 4 illustrates a state where the power feeding coil 31 and the power transmission coil 32 resonate and the power transmission coil 32 and the power reception coil 41 are resonating. A mutual inductance L₀ between the power feeding coil 31 and the power transmission coil 32 is k₀₁√(L₀L₁), and a mutual inductance L₂ between the power transmission coil 32 and the power reception coil 41 is k₁₂√(L₁L₂). In Figure 4, "Z₀" is an impedance (load-side impedance) of a circuit on the load 8 side from between the power supply 5 and the power feeding coil 31, i.e., from the input end IE of the power transmission device 3. "Z₁" is an impedance of a circuit on the load 8 side from between the power feeding coil 31 and the power transmission coil 32. "Z₂" is an impedance of a circuit on the load 8 side from between the power feeding coil 31 and the power transmission coil 32. The following equations 1 to 3 are obtained by the equivalent circuit illustrated in Figure 4.
[Equation 1]
[Equation 2]
[Equation 3]

Impedance matching in the present invention means making the load-side impedance Z₀ of the circuit as viewed toward the load 8 side from the input end IE of the power transmission device 3 match the input-side impedance Zₛ of the power supply 5 and keeping the load-side impedance Z₀ substantially constant when the load resistance R_{L} has changed.

Specifically, in the wireless power feeding system 1, when power of the load 8 is high and an impedance of the load 8 is low, the impedance Z₂ of the circuit on the load 8 side from between the power feeding coil 31 and the power transmission coil 32 decreases, as can be seen from the equation (1). At this time, the impedance Z₁ of the circuit on the load 8 side from between the power feeding coil 31 and the power transmission coil 32 increases, as can been seen from the equation (2), and the load-side impedance Z₀ decreases, as can be seen from the equation (3). That is, the load-side impedance Z₀ decreases, while the input-side impedance Zₛ does not vary.

When power is fed to the power feeding coil part 31A closest to the power transmission coil 32 under switching control of the switches 91a to 91d, magnetic field coupling to the power transmission coil 32 becomes tight and the coupling coefficient k₀₁ increases. When the coupling coefficient k₀₁ between the power feeding coil 31 and the power transmission coil 32 is increased at a ratio equal to a ratio at which the impedance Z₁ of the circuit on the load 8 side from between the power feeding coil 31 and the power transmission coil 32 increases, the load-side impedance Z₀ can be kept constant. Thus, when the load-side impedance Z₀ continues to be controlled to an impedance substantially equal to the input-side impedance Zₛ, power reflection is suppressed, thereby making it possible to implement an efficient system driving situation.

When power of the load 8 is low and an impedance of the load 8 is high, the impedance Z₂ of the circuit on the load 8 side from between the power feeding coil 31 and the power transmission coil 32 increases, as can be seen from the equation (1). At this time, the impedance Z₁ of the circuit on the load 8 side from between the power feeding coil 31 and the power transmission coil 32 decreases, as can been seen from the equation (2), and the load-side impedance Z₀ increases, as can be seen from the equation (3). That is, the load-side impedance Z₀ increases, while the input-side impedance Zₛ does not vary.

When power is fed to either one of the power feeding coil parts 31B and 31C under switching control of the switches 91a to 91d, magnetic field coupling to the power transmission coil 32 becomes loose and the coupling coefficient k₀₁ decreases depending on a distance between the power transmission coil 32 and the power feeding coil parts 31B and 31C. When the coupling coefficient k₀₁ between the power feeding coil 31 and the power transmission coil 32 is decreased at a ratio equal to a ratio at which the impedance Z₁ of the circuit on the load 8 side from between the power feeding coil 31 and the power transmission coil 32 decreases, the load-side impedance Z₀ can be kept constant. Thus, when the load-side impedance Z₀ continues to be controlled to an impedance substantially equal to the input-side impedance Zₛ, power reflection is suppressed, thereby making it possible to implement an efficient system driving situation.

The storage unit 93 stores a relationship between a load voltage and a load current to be outputted from the DC-DC converter 7 and fed to the load 8 and a relationship between a load current and a load-side impedance. The load voltage and the load current to be fed to the load 8 are measured in real time and continuously by a measurement unit 95 provided between the DSC-DC converter 7 and the load 8. The measurement unit 95 is not limited to one that measures a load voltage, but may be one that measures a load current, or may be both of them. The load voltage and the load current in the present embodiment are respectively an output voltage and an output current from the DC-DC converter 7, in other words, an input voltage and an input current of the load 8. The measurement unit 95 can be arranged between the capacitor 62 and the DC-DC converter 7. In this case, the load voltage and the load current are respectively an input voltage and an input current of the DC-DC converter 7. Further, when the DC-DC converter 7 is not arranged, the load voltage and the load current are respectively an input voltage and an input current of the load 8.

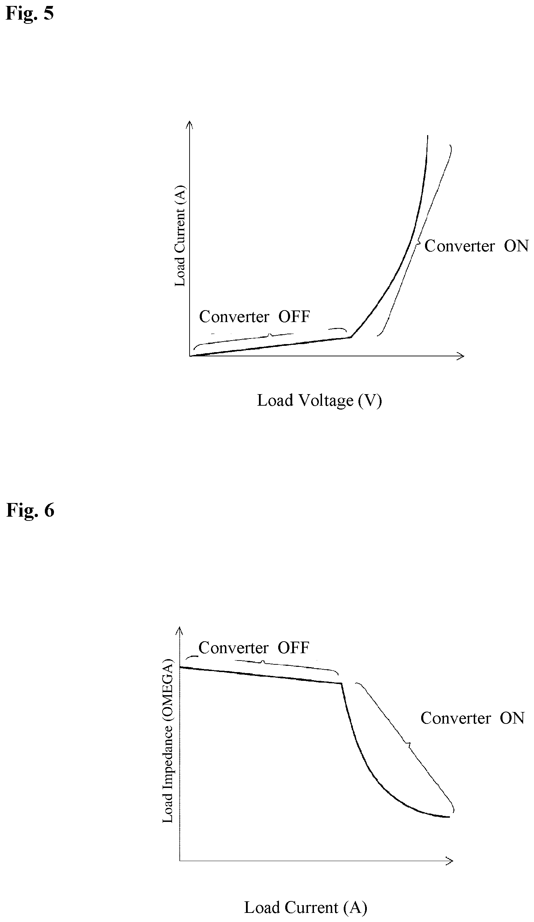

Specifically, as illustrated in Figure 5, the relationship between the load voltage and the load current includes a relationship between a load voltage and a load current in an idling state where an input voltage to the DC-DC converter 7 is equal to or less than an operating voltage (e.g., 12 V) of the DC-DC converter 7 and the DC-DC converter 7 is not operating (the converter is off) and a relationship between a load voltage and a load current in a state where an input voltage to the DC-DC converter 7 exceeds operating power of the DC-DC converter 7 and the DC-DC converter 7 is operating (the converter is on).

As illustrated in Figure 6, the relationship between the load current and the load-side impedance includes a relationship between a load current and a load-side impedance in a state where the DC-DC converter 7 is idling (the converter is off) and a relationship between a load current and a load-side impedance in a state where the DC-DC converter 7 is not operating (the converter is on).

The relationship between the load voltage and the load current and the relationship between the load current and the load-side impedance may be previously calculated by an experiment or the like, or may be treated as a function by calculation. The relationship between the load voltage and the load current and the relationship between the load current and the load-side impedance are not respectively limited to graphs illustrated in Figures 5 and 6.

The control unit 94 controls switching of the switches 91a to 91d on the basis of a measurement value of the measurement unit 95 and the relationships stored in the storage unit 93. Details of the switching control of the switches 91a to 91d by the control unit 94 will be described below.

Thus, the wireless power feeding system 1 according to the present embodiment can immediately change a positional relationship between the power feeding coil 31 and the power transmission coil 32 by the impedance matching mechanism 9 depending on a variation of the load-side impedance measured by the measurement unit 95, and can alleviate a difference between the input-side impedance at the input end IE and the load-side impedance in real time.

### <Impedance Matching Processing>

Then, impedance matching processing to be performed by the impedance matching mechanism 9 will be described with reference to the drawings.

First, the reason why a load-side impedance varies depending on whether the DC-DC converter 7 is on or off will be described. Although a case where the load-side impedance varies depending on whether the DC-DC converter 7 is on or off will be described as an example in the present embodiment, it is needless to say that the variation of the load-side impedance can occur depending on not only whether the DC-DC converter 7 is on or off but also a change of a relative position between the power transmission coil 32 and the power reception coil 41 and a change of a driving situation (output) of the load 8, for example, and can be used to suppress the variation of the load-side impedance due to various such factors.

As illustrated in Figure 5, in a state where the DC-DC converter 7 is idling (the converter is off), an output voltage of the DC-DC converter 7 is equal to or less than 12 V as an operating voltage, for example, and a load current also becomes very small. A load current in a case where the measurement unit 95 is arranged between the DC-DC converter 7 and the load 8 (an output current of the DC-DC converter 7) is substantially zero, and a load current in a case where the measurement unit 95 is arranged between the capacitor 62 and the DC-DC converter 7 (an input current of the DC-DC converter 7) slightly increases until it reaches the operating voltage (e.g., 12 V). A load-side impedance at this time becomes significantly high, as illustrated in Figure 6. Although a load-side impedance in a case where the above-described measurement unit 95 is arranged between the DC-DC converter 7 and the load 8 has a substantially constant value (a value corresponding to power of a load targeted by a device), the load-side impedance slightly decreases when the measurement unit 95 is arranged between the capacitor 62 and the DC-DC converter 7.

Then, when the DC-DC converter 7 starts to operate (the converter is on) so that power is fed to the load 8, as illustrated in Figure 5, an output voltage (load voltage) of the DC-DC converter 7 increases to an operating voltage (e.g., 12 V), and an output current (load current) of the DC-DC converter 7 rapidly increases. A load-side impedance at this time rapidly decreases and asymptotically approaches a predetermined value with an elapse of time, as illustrated in Figure 6. The same is true for a case where the measurement unit 95 is arranged between the capacitor 62 and the DC-DC converter 7. To reliably prevent the load-side impedance from varying at the time point where feeding of power to the load 8 is started, a value of the load-side impedance is previously adjusted in an idling state before the DC-DC converter 7 starts to operate.

Thus, the load-side impedance varies depending on an operating state of the DC-DC converter 7, while the input-side impedance is fixed to a predetermined value (e.g., 50 Ω). Accordingly, the input-side impedance and the load-side impedance do not match each other, and a reflected wave occurs at the input end IE, resulting in a decrease in transmission efficiency and insufficient transmission power, which may lead to a system failure.

The controller 92 increases or decreases an impedance of a circuit in the power transmission device 3 depending on the variation of the load-side impedance.

Specifically, the control unit 94 first calculates a load current on the basis of the load voltage measured by the measurement unit 95 and Figure 5. The control unit 94 calculates a load-side impedance on the basis of the calculated load current and Figure 6.

Then, the control unit 94 switches the switches 91a to 91d such that the load-side impedance matches an input-side impedance, to determine to which of the power feeding coil parts 31A, 31B, and 31C power is fed and to adjust the impedance of the circuit in the power transmission device 3.

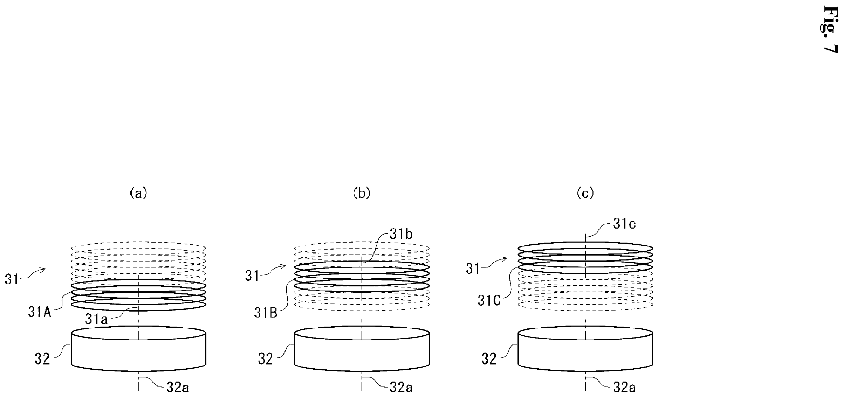

In a state where the DC-DC converter 7 is idling and the load-side impedance is higher than the input-side impedance, for example, power is fed to the power feeding coil part 31A, as illustrated in Figure 7(a), whereby magnetic field coupling between the power feeding coil 31 and the power transmission coil 32 becomes tight and a coupling coefficient increases.
As a result, the load-side impedance at the input end IE decreases, as described above, and a difference between the load-side impedance and the input-side impedance is alleviated.

On the other hand, in a state where the DC-DC converter 7 operates and the load-side impedance becomes lower than the input-side impedance, power is fed to the power feeding coil part 31B farther from the power transmission coil 32 than the power feeding coil part 31A, as illustrated in Figure 7(b), whereby magnetic field coupling between the power feeding coil 31 and the power transmission coil 32 becomes loose and a coupling coefficient decreases. As a result, the load-side impedance at the input end IE increases, and a difference between the load-side impedance and the input-side impedance is alleviated.

When the load-side impedance further decreases, power is fed to the power feeding coil part 31C farthest from the power transmission coil 32, as illustrated in Figure 7(c), whereby magnetic field coupling between the power feeding coil 31 and the power transmission coil 32 further becomes loose and a coupling coefficient decreases. As a result, the load-side impedance at the input end IE further increases, and a difference between the load-side impedance and the input-side impedance is alleviated.

As a relationship between a distance between each of the power feeding coil parts 31A, 31B, and 31C and the power transmission coil 32 and a change amount of a coupling coefficient, one previously obtained by an experiment or the like is used.

Thus, the wireless power feeding system 1 according to the present embodiment is the wireless power feeding system 1 that transmits and receives power using magnetism, the wireless power feeding system 1 including the power transmission device 3 that includes the power transmission-side resonance circuit 36 including the power transmission coil 32 and the power feeding coil 31 that is provided to be capable of magnetic field coupling to the power transmission coil 32 and transmits power to be fed from the input end IE to the power transmission coil 32, the power reception device 4 that includes the power reception-side resonance circuit 43 including the power reception coil 41 and feeds power received by the power reception coil 41 to the load 8, and the impedance matching mechanism 9 that performs impedance matching processing for alleviating a difference between a load-side impedance as an impedance of a circuit on the load 8 side from the input end IE of the power transmission device 3 and an input-side impedance as an impedance of a circuit on the AC power supply 5 side from the input end IE of the power transmission device 3 by changing a coupling strength in magnetic field coupling between the power feeding coil 31 and the power transmission coil 32.

According to this configuration, when the load-side impedance and the input-side impedance do not match each other, the impedance matching mechanism 9 changes strength and weakness of coupling in magnetic field coupling (looseness and tightness of magnetic field coupling) between the power feeding coil 31 and the power transmission coil 32, to alleviate the difference between the input-side impedance and the load-side impedance. Accordingly, a reflected wave is prevented from being generated at the input end IE, thereby making it possible to avoid a decrease in transmission efficiency and a system failure caused by a decrease in transmission power.

In the wireless power feeding system 1 according to the present embodiment, the power feeding coil 31 is divided into the plurality of power feeding coil parts 31A, 31B, and 31C that differ in coupling strength in magnetic field coupling to the power transmission coil 32 and is configured to be able to feed power to at least any one of the plurality of power feeding coil parts 31A, 31B, and 31C, and the impedance matching mechanism 9 is configured to feed power to at least one of the plurality of power feeding coil parts 31A, 31B, and 31C.

According to this configuration, when power is fed to any one of the power feeding coil parts 31A, 31B, and 31C that differ in coupling strength in magnetic field coupling to the power transmission coil 32, an impedance of a circuit in the power transmission device 3 increases or decreases so that a difference between an input-side impedance and a load-side impedance is alleviated. Accordingly, a reflected wave is prevented from being generated at the input end IE, thereby making it possible to avoid a decrease in transmission efficiency and a system failure caused by a decrease in transmission power.

The wireless power feeding system 1 according to the present embodiment is configured such that the plurality of power feeding coil parts 31A, 31B, and 31C respectively include the coil axes 31a, 31b, ad 31c arranged substantially coaxially with one another and respective distances thereof from the power transmission coil 32 differ from one another.

According to this configuration, coupling strengths in magnetic field coupling between the power feeding coil parts 31A, 31B, and 31C and the power transmission coil 32 respectively decrease in inverse proportion to the distances of the power feeding coil parts 31A, 31B, and 31C from the power transmission coil 32. Accordingly, power is fed to any one of the power feeding coil parts 31A, 31B, and 31C that differ in coupling strength in magnetic field coupling to the power transmission coil 32, thereby making it possible to increase or decrease the impedance of the circuit in the power transmission device 3.

The wireless power feeding system 1 according to the present embodiment is configured such that power is fed from the power feeding coil 31 to the power transmission coil 32 using a magnetic field resonance method and respective inductance values of the power feeding coil parts 31A, 31B, and 31C are set substantially equal to one another.

This configuration makes it possible to efficiently feed the power using the magnetic field resonance method to the power transmission coil 32 from the power feeding coil parts 31A, 31B, and 31C that differ in positions relative to the power transmission coil 32.

The wireless power feeding system 1 according to the present embodiment further includes the measurement unit 95 that measures a load current to be fed to the load 8 and a load voltage to be applied to the load 8 and is configured such that the impedance matching mechanism 9 performs impedance matching processing depending on a measurement result of the measurement unit 95.

According to this configuration, the impedance matching mechanism 9 alleviates a difference between an input-side impedance and a load-side impedance depending on the measurement result of the measurement unit 95. Accordingly, a reflected wave is prevented from being generated at the input end IE, thereby making it possible to avoid a decrease in transmission efficiency and a system failure caused by a decrease in transmission power.

The wireless power feeding system 1 according to the present embodiment is configured such that power is fed from the power transmission coil 32 to the power reception coil 41 using a magnetic field resonance method.

This configuration makes it possible to efficiently feed power from the power transmission coil 32 to the power reception coil 41.

The wireless power feeding method using the wireless power feeding system 1 according to the present embodiment is the wireless power feeding method using the wireless power feeding system 1 that transmits and receives power using magnetism and includes the power transmission device 3 that includes the power transmission-side resonance circuit 36 including the power transmission coil 32 and the power feeding coil 31 that is provided to be capable of magnetic field coupling to the power transmission coil 32 and transmits power to be fed from the input end IE to the power transmission coil 32 and the power reception device 4 that includes the power reception-side resonance circuit 43 including the power reception coil 41 and feeds power received by the power reception coil 41 to the load 8, the wireless power feeding method including alleviating a difference between a load-side impedance as an impedance of a circuit on the load 8 side from the input end IE of the power transmission device 3 and an input-side impedance as an impedance of a circuit on the AC power supply 5 side from the input end IE of the power transmission device 3 by changing a coupling strength in magnetic field coupling between the power feeding coil 31 and the power transmission coil 32 using the impedance matching mechanism 9.

According to this configuration, when the load-side impedance and the input-side impedance do not match each other, the impedance matching mechanism 9 changes strength and weakness of coupling in magnetic field coupling between the power feeding coil 31 and the power transmission coil 32, to alleviate the difference between the input-side impedance and the load-side impedance. Accordingly, a reflected wave is prevented from being generated at the input end IE, thereby making it possible to avoid a decrease in transmission efficiency and a system failure caused by a decrease in transmission power.

The wireless power transmission system 11 according to the present embodiment is the wireless power transmission system 11 that transmits power using magnetism to the power reception device 4, the wireless power transmission system 11 being configured to include the power transmission device 3 that includes the power transmission-side resonance circuit 36 including the power transmission coil 32 and the power feeding coil 31 that is provided to be capable of magnetic field coupling to the power transmission coil 32 and transmits power to be fed from the input end IE to the power transmission coil 32 and that transmits the power to the load 8 via the power reception device 4, and the impedance matching mechanism 9 that performs impedance matching processing for alleviating a difference between a load-side impedance as an impedance of a circuit on the load 8 side from the input end IE of the power transmission device 3 and an input-side impedance as an impedance of a circuit on the AC power supply 5 side from the input end IE of the power transmission device 3 by changing a coupling strength in magnetic field coupling between the power feeding coil 31 and the power transmission coil 32.

According to this configuration, when the load-side impedance and the input-side impedance do not match each other, the impedance matching mechanism 9 changes strength and weakness of coupling in magnetic field coupling between the power feeding coil 31 and the power transmission coil 32, to alleviate the difference between the input-side impedance and the load-side impedance. Accordingly, a reflected wave is prevented from being generated at the input end IE, thereby making it possible to avoid a decrease in transmission efficiency and a system failure caused by a decrease in transmission power.

Although a configuration in which an input-side impedance and a load-side impedance previously match each other when the DC-DC converter 7 is idling is illustrated as an example in the present embodiment, a configuration in which the input-side impedance and the load-side impedance previously match each other when the DC-DC converter 7 shifts from idling to an on state or when the load-side impedance is stabilized after the DC-DC converter 7 is turned on may be used.

### <Experiment Example>

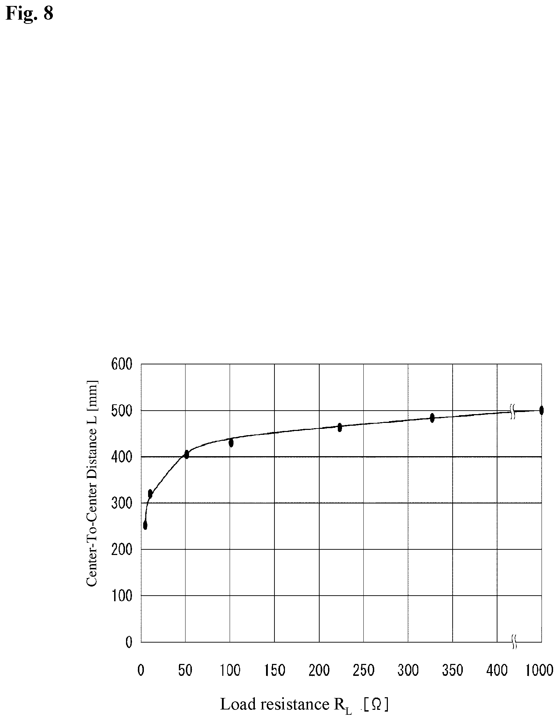

Then, a simulation performed to confirm an effect and feasibility of the wireless power feeding system 1 according to the present embodiment will be described. In the simulation, when respective diameters of the power feeding coil 31 and the power transmission coil 32 were each set to 70 mm and a load resistance RL of the load 8 was changed assuming that the power feeding coil 31 and the power transmission coil 32 were each maintained in a resonance state and the power transmission coil 32 and the power reception coil 41 were each maintained in a resonance state, a center-to-center distance L in an axial direction of the coil axis 31a (31b, 31c) between the power feeding coil 31 and the power transmission coil 32 to be in an impedance matching state was calculated. A numerical value of the load resistance RL was assumed to include respective load resistance values of the rectifying circuit 6 and the DC-DC converter 7. An actual load resistance of the load 8 considering respective load resistances of the rectifying circuit 6 and the DC-DC converter 7 in a case where an output voltage of the DC-DC converter 7 was set to 48 V was also calculated. Their results are illustrated in Table 1 and Figure 8. Figure 8 is a graph with the load resistance RL set as a horizontal axis and the center-to-center distance L between the power feeding coil 31 and the power transmission coil 32 set as a vertical axis during impedance matching. In Table 1 and Figure 8, when the load 8 is off, the load resistance RL is 1000 Ω or more (the actual load resistance of the load 8 is 1000 Ω or more) and the center-to-center distance L at this time is 500 mm for convenience.

**[Table 1]**

| | |
|---|---|
| ① | Load |
| ② | Load resistance RL [Ω] |
| ③ | Actual load resistance [Ω] |
| ④ | Driving power [W] |
| ⑤ | Distance between power feeding coil and power transmission coil (center-to-center distance L) [mm] |

According to Figure 8, when the power feeding coil part 31A, the power feeding coil part 31B, and the power feeding coil part 31C are respectively arranged in positions spaced 300 mm, 400 mm, and 500 mm away from the power transmission coil 32, a load current is measured by the measurement unit 95 to calculate a value of driving power of the load 8, and the switches 91a to 91d are switched depending on the calculated driving power of the load 8, to switch the power feeding coil parts 31A, 31B, and 31C. Specifically, the power feeding coil part 31A, the power feeding coil part 31B, and the power feeding coil part 31C are operated, respectively, when the driving power of the load 8 is 200 W or more, when the driving power of the load 8 is 20 W or more and less than 200 W, and when the load 8 is off or the driving power of the load 8 is less than 20 W.

The number of power feeding coils 31 is increased, thereby making it possible to implement impedance matching processing with a higher accuracy. For example, the number of power feeding coils 31 is increased to six, and installation positions of the power feeding coils 31 from the power transmission coil 32 are respectively set to positions at center-to-center distances L of 250 mm, 300 mm, 350 mm, 400 mm, 450 mm, and 500 mm. In this case, the power feeding coil at the center-to-center distance L of 250 mm, the power feeding coil at the center-to-center distance L of 300 mm, the power feeding coil at the center-to-center distance L of 350 mm, the power feeding coil at the center-to-center distance L of 400 mm, the power feeding coil at the center-to-center distance L of 450 mm, and the power feeding coil at the center-to-center distance L of 500 mm are operated, respectively, when the driving power of the load 8 is 700 W or more, when the driving power of the load 8 is 350 W or more and less than 700 W, when the driving power of the load 8 is 200 W or more and less than 350 W, when the driving power of the load 8 is 50 W or more and less than 200 W, when the driving power of the load 8 is 10 W or more and less than 50 W, and when the load 8 is off or the driving power of the load 8 is less than 10 W.

The plurality of power feeding coils 31 need not necessarily be arranged with equal spacing, and the spacing between the power feeding coils 31 to be arranged may be changed, as needed. For example, the number of the power feeding coils 31 to be installed in a low driving power region where driving power rapidly increases by activating the load 8 may be made larger than the number of the power feeding coils 31 to be installed in a high driving power region where driving power of the load 8 is high and is stable to some extent. Specifically, when the six power feeding coils 31 are provided, installation positions of the power feeding coils 31 are respectively positions at the center-to-center distances L of 300 mm, 400 mm, 440 mm, 470 mm, 490 mm, and 500 mm from the power transmission coil 32. In this case, the power feeding coil 31 arranged at the center-to-center distance L of 300 mm, the power feeding coil 31 arranged at the center-to-center distance L of 400 mm, the power feeding coil 31 arranged at the center-to-center distance L of 440 mm, the power feeding coil 31 arranged at the center-to-center distance L of 470 mm, the power feeding coil 31 arranged at the center-to-center distance L of 490 mm, the power feeding coil 31 arranged at the center-to-center distance L of 500 mm are operated, respectively, when the driving power of the load 8 is 500 W or more, when the driving power of the load 8 is 60 W or more and less than 500 W, when the driving power of the load 8 is 30 W or more and less than 60 W, when the driving power of the load 8 is 15 W or more and less than 30 W, when the driving power of the load 8 is 5 W or more and less than 15 W, and when the load 8 is off or the driving power of the load 8 is less than 5 W.

### <Modification 1>

Then, a modification to the present embodiment will be described. In the modification, other components excluding components described below are similar to the components in the above-described embodiment.

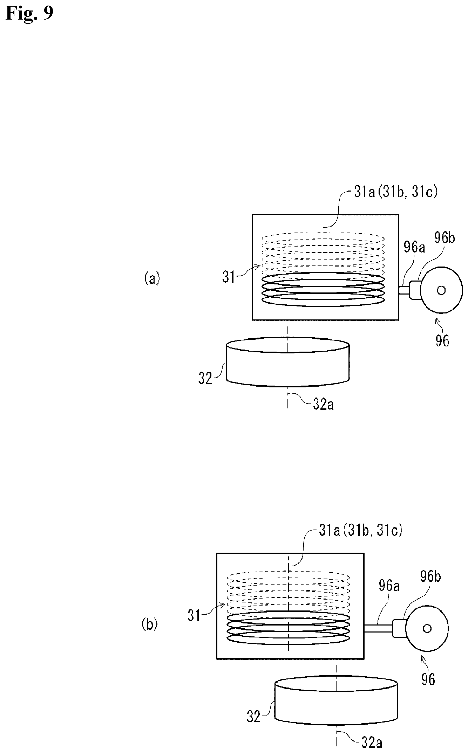

An impedance matching mechanism 9 may include a coil movement mechanism 96 that moves a power feeding coil 31 relative to a power transmission coil 32, as illustrated in Figures 9(a) and 9(b).

The coil movement mechanism 96 is a solenoid including a plunger 96a and a case 96b. The power feeding coil 31 is connected to a tip end of the plunger 96a. The plunger 96a advances and retreats to and from coil axes 31a, 31b, 31c in a vertical direction, to slide the power feeding coil 31 such that each of the coil axes 31a, 31b, and 31c separates from or comes closer to (match) a coil axis 32a of the power transmission coil 32 while the coil axes 31a, 31b, and 31c and the coil axis 32a are maintained in a substantially parallel state.

Specifically, when a position of the power feeding coil 31 at the time when the coil axes 31a, 31b, and 31c are positioned coaxially with the coil axis 32a of the power feeding coil 32 is set as an original position, as illustrated in Figures 2(a) to 2(c), the plunger 96a retreats so that the power feeding coil 31 moves away from the original position in a direction perpendicular to the coil axes 31a, 31b, and 31c, as illustrated in Figure 9(a), and the plunger 96a advances so that the power feeding coil 31 moves away from the original position in the direction perpendicular to the coil axes 31a, 31b, and 31c, as illustrated in Figure 9(b).

When the coil axes 31a, 31b, and 31c and the coil axis 32a of the power transmission coil 32 are coaxially positioned, magnetic field coupling to the power transmission coil 32 becomes tight (a coupling strength (coupling coefficient) increases). On the other hand, when the coil axes 31a, 31b, and 31c are offset in a direction perpendicular to the coil axis 31a with respect to the coil axis 32a of the power transmission coil 32, magnetic field coupling to the power transmission coil 32 becomes loose (a coupling strength (coupling coefficient) decreases).

As a relationship between an offset amount between the coil axis 31a of the power feeding coil 31 and the coil axis 32a of the power transmission coil 32 (a stroke amount of the plunger 96a) and a change amount of an impedance of a circuit in a power transmission device 3, one previously obtained by an experiment or the like is used.

A stroke range (one side) of the plunger 96a is set equal to or less than the radius of the power feeding coil 31, for example. As a result, even when the power feeding coil 31 maximally moves in any direction perpendicular to the coil axes 31a, 31b, and 31c, a state where at least a portion of the power feeding coil 31 overlaps at least a portion of the power transmission coil 32, as viewed in an axial direction of the coil axes 31a, 31b, and 31c can be kept.

A mechanism for moving the power feeding coil 31 relative to the power transmission coil 32 using the coil movement mechanism 96 is inferior in responsiveness to a configuration in which the switches 91a to 91d are electrically switched. Accordingly, the power feeding coil 31 is moved relative to the power transmission coil 32 to finely adjust an impedance after roughly adjusting the impedance under switching control of the switches 91a to 91d, for example, so that the impedance can be smoothly optimized. The impedance may be optimized by finely adjusting the impedance under switching control of the switches 91a to 91d after roughly adjusting the impedance by moving the power feeding coil 31 relative to the power transmission coil 32.

### <Modification 2>

Although a configuration in which the coil movement mechanism 96 moves the power feeding coil 31 such that the coil axis 31a of the power feeding coil 31 is offset in the direction perpendicular to the coil axis 32a of the power transmission coil 32 is illustrated as an example in the above-described modification 1, a configuration in which a coil movement mechanism 96 moves a power feeding coil 31 parallel to an axial direction of coil axes 31a, 31b, and 31c and a coil axis 32a may be used.

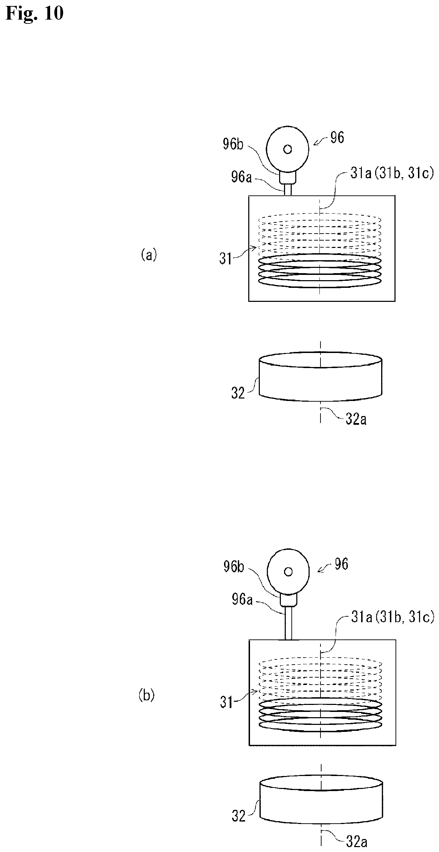

For example, when a position of the power feeding coil 31 at the time when the coil axes 31a, 31b, and 31c are positioned coaxially with the coil axis 32a of a power transmission coil 32 is set as an original position, as illustrated in Figures 2(a) to 2(c), there is considered a configuration of the coil movement mechanism 96 in which a plunger 96a retreats so that the power feeding coil 31 moves in a direction parallel to the coil axes 31a, 31b, and 31c from the original position and away from the power transmission coil 32, as illustrated in Figure 10(a), and the plunger 96a advances so that the power feeding coil 31 moves in the direction parallel to the coil axes 31a, 31b, and 31c from the original position and nearer to the power transmission coil 32, as illustrated in Figure 10(b).

As described above, the closer power feeding coil parts 31A, 31B, and 31C come to the power transmission coil 32, the tighter magnetic field coupling thereof to the power transmission coil 32 becomes (the larger a coupling coefficient becomes), and the farther the power feeding coil parts 31A, 31B, and 31C move away from the power transmission coil 32, the looser magnetic field coupling thereof to the power transmission coil 32 becomes (the smaller a coupling coefficient becomes).

As a relationship between an amount in which the coil movement mechanism 96 moves the power feeding coil 31 (a stroke amount of the plunger 96a) and a change amount of an impedance of a circuit in a power transmission device 3, one previously obtained by an experiment or the like is used.

A mechanism for moving the power feeding coil 31 relative to the power transmission coil 32 using the coil movement mechanism 96 is inferior in responsiveness to a configuration in which switches 91a to 91d are electrically switched. Accordingly, when the power feeding coil 31 is moved relative to the power transmission coil 32 to finely adjust an impedance after roughly adjusting the impedance under switching control of the switches 91a to 91d, for example, the impedance can be smoothly optimized even when its value has greatly changed.

Specifically, first, the power feeding coil part 31A is arranged in a position spaced a center-to-center distance L of 300 mm away from the power transmission coil 32, the power feeding coil part 31B is arranged in a position spaced a center-to-center distance L of 400 mm away from the power transmission coil 32, the power feeding coil part 31C is arranged in a position spaced a center-to-center distance L of 500 mm away from the power transmission coil 32, the power feeding coil parts 31A, 31B, and 31C constitute one unit, and the coil movement mechanism 96 is configured to be able to respectively move the power feeding coil parts 31A, 31B, and 31C in a range of ± 50 mm parallel to the coil axes 31a, 31b, and 31c. That is, the power feeding coil part 31A is movable at a center-to-center distance L within a range of 250 to 350 mm, the power feeding coil part 31B is movable at a center-to-center distance L within a range of 350 to 450 mm, and the power feeding coil part 31C is movable at a center-to-center distance L within a range of 450 to 550 mm.

For example, the power feeding coil part 31A is used if driving power of the load 8 is 300 W or more and less than 1000 W, the power feeding coil part 31B is used if driving power of the load 8 is 30 W or more and less than 300 W, and the power feeding coil part 31C is used if the load 8 is off or driving power of the load 8 is less than 50 W, and then the power feeding coil parts 31A, 31B, and 31C are moved relative to the power transmission coil 32, to optimize an impedance.

The impedance may be optimized by finely adjusting the impedance under switching control of the switches 91a to 91d after roughly adjusting the impedance upon moving the power feeding coil 31 relative to the power transmission coil 32 by the coil movement mechanism 96. In this case, the impedance can be finely adjusted at high speed. Accordingly, the impedance can be smoothly optimized even when it has rapidly changed.

Specifically, the power feeding coil 31 formed by arranging the power feeding coil parts 31A, 31B, and 31C to be spaced 50 mm away from one another is set as one unit, and the coil movement mechanism 96 is configured such that the power feeding coil parts 31A, 31B, and 31C are movable by 100 mm or 200 mm parallel to the coil axes 31a, 31b, and 31c and in a direction away from the power transmission coil 32.

The impedance is optimized by using the power feeding coil part 31B if driving power of the load 8 is 700 W or more and using the power feeding coil part 31C if driving power of the load 8 is 350 W or more and less than 700 W in a state where the power feeding coil part 31A is arranged in a position at a center-to-center distance L of 200 mm, the power feeding coil part 31B is arranged in a position at a center-to-center distance L of 250 mm, and the power feeding coil part 31C is arranged in a position at a center-to-center distance L of 300 mm.

The impedance is optimized by using the power feeding coil part 31A if driving power of the load 8 is 350 W or more and less than 700 W, using the power feeding coil part 31B if driving power of the load 8 is 200 W or more and less than 350 W, and using the power feeding coil part 31C if driving power of the load 8 is 50 W or more and less than 200 W in a state where the coil movement mechanism 96 moves each of the power feeding coil parts 31A, 31B, and 31C by 100 mm in a direction away from the power transmission coil 32 so that the power feeding coil part 31A is arranged in a position at a center-to-center distance L of 300 mm, the power feeding coil part 31B is arranged in a position at a center-to-center distance L of 350 mm, and the power feeding coil parts 31C is arranged in a position at a center-to-center distance L of 400 mm.

Further, the impedance is optimized by using the power feeding coil part 31A if driving power of the load 8 is 50 W or more and less than 200 W, using the power feeding coil part 31B if driving power of the load 8 is 10 W or more and less than 50 W, and using the power feeding coil part 31C if the load 8 is off or the driving power of the load 8 is less than 10 W in a state where the coil movement mechanism 96 moves each of the power feeding coil parts 31A, 31B, and 31C by 200 mm in a direction away from the power transmission coil 32 so that the power feeding coil part 31A is arranged in a position at a center-to-center distance L of 400 mm, the power feeding coil part 31B is arranged in a position at a center-to-center distance L of 450 mm, and the power feeding coil parts 31C is arranged in a position at a center-to-center distance L of 500 mm.

### <Modification 3>

Although the power feeding coil 31 constituted by the power feeding coil parts 31A, 31B, and 31C in which the coil axes 31a, 31b, and 31c are respectively arranged substantially coaxially with one another is illustrated as an example in the above-described embodiment, a configuration of a power feeding coil 31 is not limited to this.

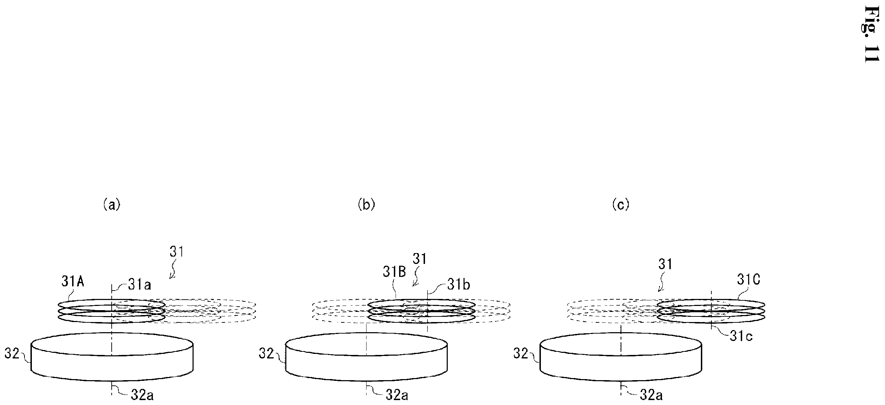

For example, the power feeding coil 31 may include power feeding coil parts 31A, 31B, and 31C arranged such that coil axes 31a, 31b, and 31c are offset to be substantially parallel to and away from one another, as illustrated in Figures 11(a) to 11(c) .

At this time, the larger the opposing area between the power feeding coil 31 and a power transmission coil 32 is, the tighter magnetic field coupling therebetween becomes. Therefore, as illustrated in Figure 11(a), in the power feeding coil part 31A, the coil axis 31a and a coil axis 32a are coaxially positioned, whereby magnetic field coupling to the power transmission coil 32 becomes tightest. As illustrated in Figure 11(b), in the power feeding coil part 31B, the coil axis 31b separates from the coil axis 32a, whereby magnetic field coupling to the power transmission coil 32 becomes loose. Further, as illustrated in Figure 11(c), in the power feeding coil part 31C, the coil axis 31c most separates from the coil axis 32a, whereby magnetic field coupling to the power transmission coil 32 becomes loosest. According to such a configuration, power is selectively fed to any one of the power feeding coil parts 31A, 31B, and 31C under switching control of switches 91a to 91d. Accordingly, a coupling strength (coupling coefficient) between the power feeding coil 31 and the power transmission coil 32 can be adjusted.

### <Modification 4>

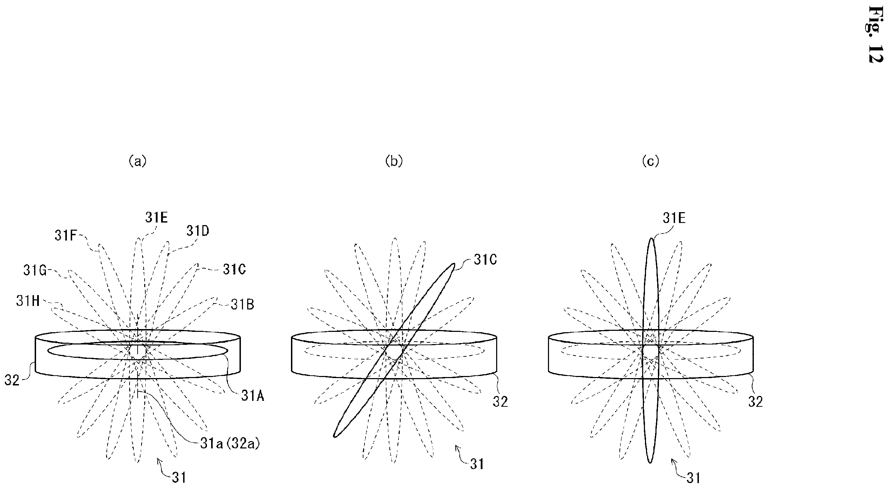

A power feeding coil 31 may include eight power feeding coil parts 31A to 31H arranged in a spherical shape, as illustrated in Figures 12(a) to 12(c), for example.

The power feeding coil 31 includes the power feeding coil parts 31A to 31H inclined with respect to one another with their respective centers matching one another. The power feeding coil parts 31A to 31H are obtained by dividing one coil into eight and are connected substantially in series. Although details of a connection relationship among the power feeding coil parts 31A to 31H are omitted, the power feeding coil parts 31A to 31H are connected to one another such that power from an AC power supply 5 can be fed to at least any one of the power feeding coil parts 31A to 31H by a switch not illustrated, for example, like in Figure 2.

As illustrated in Figure 12(a), the power feeding coil part 31A is accommodated in a power transmission coil 32 with its coil axis 31a and a coil axis 32a of the power transmission coil 32 substantially match each other, i.e., without being inclined with respect to the power transmission coil 32. As illustrated in Figure 12(b), the power feeding coil part 31C has its portion accommodated in the power feeding coil 32 while being inclined by about 45 degrees with respect to the power transmission coil 32. As illustrated in Figure 12(c), the power feeding coil part 31E has its portion accommodated in the power transmission coil 32 while being inclined by about 90 degrees with respect to the power transmission coil 32. Further, the power feeding coil parts 31B, 31D, and 31F to 31H have their respective portions accommodated in the power transmission coil 32 while being respectively inclined by about 22.5 degrees, about 67.5 degrees, about 112.5 degrees, about 135 degrees, and about 157.5 degrees with respect to the power transmission coil 32.

At this time, the larger the opposing area between the power feeding coil 31 and the power transmission coil 32 is, the tighter magnetic field coupling therebetween becomes.
That is, magnetic field coupling of the power feeding coil part 31A to the power transmission coil 32 becomes tightest because the coil axis 31a and the coil axis 32a are coaxially positioned. Magnetic field coupling of the power feeding coil part 31E to the power transmission coil 32 becomes loosest.

This configuration makes it possible to perform impedance matching processing by appropriately switching the three power feeding coil parts 31A, 31C, and 31E, for example. That is, in a state where a DC-DC converter 7 is idling so that a load-side impedance is higher than an input-side impedance, the power feeding coil part 31A is fed with power, whereby magnetic field coupling between the power feeding coil 31 and the power transmission coil 32 becomes tight and an impedance of a circuit in a power transmission device 3 decreases, as illustrated in Figure 12(a). As a result, the load-side impedance at an input end IE decreases, and a difference between the load-side impedance and the input-side impedance is alleviated.

On the other hand, in a state where the DC-DC converter 7 operates so that the load-side impedance more decreases than the input-side impedance, the power feeding coil part 31C inclined with respect to the power transmission coil 32 is fed with power, whereby the magnetic field coupling between the power feeding coil 31 and the power transmission coil 32 becomes looser and the impedance of the circuit in the power transmission device 3 more increases than the power feeding coil part 31A, as illustrated in Figure 12(b). As a result, the load-side impedance at the input end IE increases, and the difference between the load-side impedance and the input-side impedance is alleviated.

When the load-side impedance further decreases, the power feeding coil part 31E perpendicular to the power transmission coil 32 is fed with power, whereby the magnetic field coupling between the power feeding coil 31 and the power transmission coil 32 further becomes loose and the impedance of the circuit in the power transmission device 3 further increases, as illustrated in Figure 12(c). As a result, the load-side impedance at the input end IE increases, and the difference between the load-side impedance and the input-side impedance is alleviated.

According to such a configuration, power is selectively fed to at least any one of the power feeding coil parts 31A to 31H. Accordingly, a coupling strength between the power feeding coil 31 and the power transmission coil 32 can be adjusted.

The number of the power feeding coil parts constituting the power feeding coil 31 in a spherical shape according to this modification is not limited to eight, but may be any number equal to or more than two. Although an inclination of each of the power feeding coil parts 31A to 31H to the power transmission coil 32 according to this modification is set in a range of zero degrees to 180 degrees, the inclination may be set in a range of - 90 degrees to + 90 degrees in consideration of a phase of the coil.

The power feeding coil 31 is not limited to that accommodated in the power transmission coil 32, but may be arranged outside the power transmission coil 32. Some of the power feeding coil parts 31A to 31H may be arranged in the power transmission coil 32, and the others of the power transmission coil parts 31A to 31H may be arranged outside the power transmission coil 32. When an inclination of the power feeding coil 31 with respect to the power feeding coil 31 is formed to be switchable such that a coupling coefficient k₀₁ is a geometric series, respective impedance adjustment ranges at angles of the power feeding coil 31 are substantially constant, thereby making it possible to more stably perform impedance matching.

### <Modification 5>

Although the power feeding coil 31 constituted by the power feeding coil parts 31A, 31B, and 31C respectively formed in substantially the same shapes is illustrated as an example in the above-described embodiment, power feeding coil parts 31A, 31B, and 31C may respectively have different shapes.

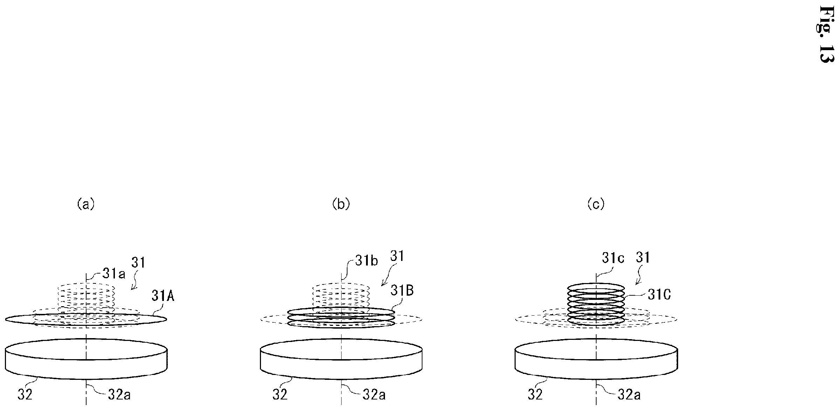

For example, as illustrated in Figures 13(a) to 13(c), a power feeding coil 31 may be configured to have a spiral shape that increases or decreases in coil diameter on substantially the same plane. At this time, coil axes 31a, 31b, and 31c are arranged substantially coaxially with one another, and the power feeding coil parts 31A, 31B, and 31C are formed such that their respective coil diameters are set to gradually decrease and their respective coil heights increase in this order. Specifically, the power feeding coil part 31A is set to have substantially the same coil diameter as that of a power transmission coil 32, the power feeding coil parts 31B and 31C are arranged on the inner periphery of the power feeding coil part 31A, and the power feeding coil part 31C is arranged on the inner periphery of the power feeding coil part 31B. When the power feeding coil 31 and the power transmission coil 32 transmit power using a magnetic field resonance method, the power feeding coil parts 31A, 31B, and 31C having different coil diameters preferably gradually increase the respective numbers of windings of the coils in this order such that their respective inductances of the power feeding coil parts 31A, 31B, and 31C are equal to one another.

At this time, the smaller a difference between the respective coil diameters of the power feeding coil 31 and the power transmission coil 32 is, the tighter magnetic field coupling therebetween becomes. Therefore, as illustrated in Figure 13(a), the power feeding coil part 31A has substantially the same coil diameter as that of the power transmission coil 32, whereby magnetic field coupling thereof to the power transmission coil 32 becomes tightest. As illustrated in Figure 13(b), the power feeding coil part 31B has a smaller coil diameter than that of the power transmission coil 32, whereby magnetic field coupling thereof to the power transmission coil 32 becomes loose. Further, as illustrated in Figure 13(c), the power feeding coil part 31C has an even smaller coil diameter than that of the power transmission coil 32, whereby magnetic field coupling thereof to the power transmission coil 32 becomes loosest. According to such a configuration, when power is selectively fed to at least any one of the power feeding coil parts 31A, 31B, and 31C under switching control of switches 91a to 91d, thereby making it possible to adjust a coupling strength between the power feeding coil 31 and the power transmission coil 32.

### <Modification 6>

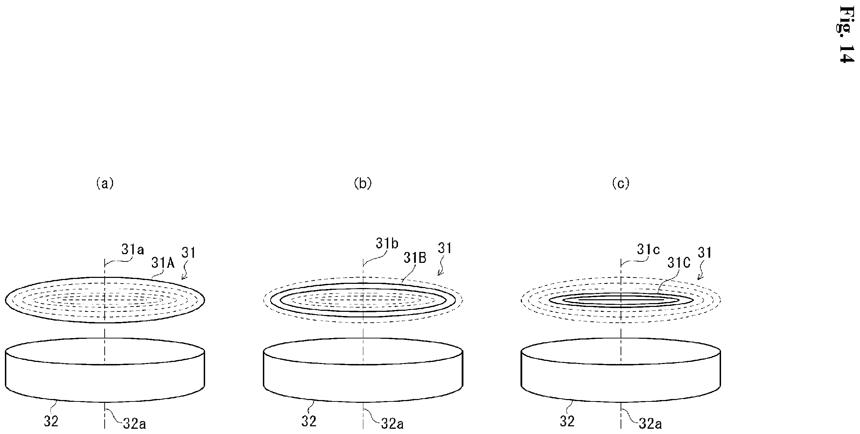

For example, as illustrated in Figures 14(a) to 14(c), a power feeding coil 31 may be configured such that its coil diameter gradually decreases toward its center from its outer periphery on substantially the same plane. At this time, coil axes 31a, 31b, and 31c are arranged substantially coaxially with one another, and power feeding coil parts 31A, 31B, and 31C are formed on substantially the same plane. Further, the power feeding coil parts 31A, 31B, and 31C are set such that their respective coil diameters gradually decrease in this order. Specifically, the power feeding coil part 31A is set to have substantially the same coil diameter as that of a power transmission coil 32, the power feeding coil parts 31B and 31C are arranged on the inner periphery of the power feeding coil part 31A, and the power feeding coil part 31C is arranged on the inner periphery of the power feeding coil part 31B. When the power feeding coil 31 and the power transmission coil 32 transmit power using a magnetic field resonance method, the power feeding coil parts 31A, 31B, and 31C having different coil diameters preferably gradually increase the respective numbers of windings of the coils in this order such that their respective inductances of the power feeding coil parts 31A, 31B, and 31C are equal to one another.

At this time, the smaller a difference between the respective coil diameters of the power feeding coil 31 and the power transmission coil 32 is, the tighter magnetic field coupling therebetween becomes. Therefore, as illustrated in Figure 14(a), the power feeding coil part 31A has substantially the same coil diameter as that of the power transmission coil 32, whereby magnetic field coupling thereof to the power transmission coil 32 becomes tightest. As illustrated in Figure 14(b), the power feeding coil part 31B has a smaller coil diameter than that of the power transmission coil 32, whereby magnetic field coupling thereof to the power transmission coil 32 becomes loose. Further, as illustrated in Figure 14(c), the power feeding coil part 31C has an even smaller coil diameter than that of the power transmission coil 32, whereby magnetic field coupling thereof to the power transmission coil 32 becomes loosest. According to such a configuration, power is selectively fed to at least any one of the power feeding coil parts 31A, 31B, and 31C under switching control of switches 91a to 91d, thereby making it possible to adjust a coupling strength (coupling coefficient) between the power feeding coil 31 and the power transmission coil 32.

### <Second Embodiment>

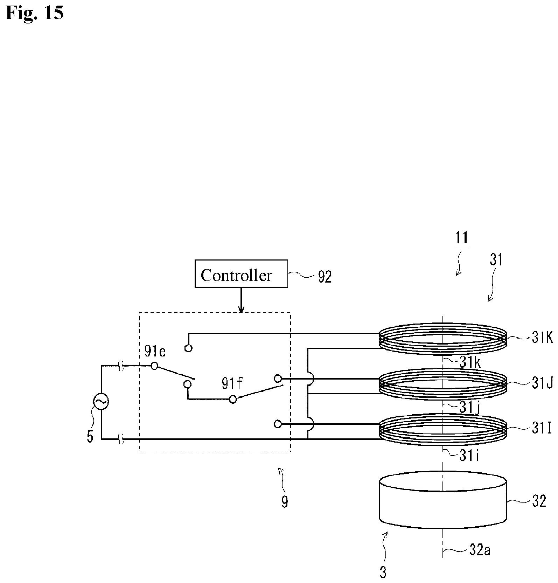

Then, a wireless power feeding system according to a second embodiment of the present invention will be described with reference to Figure 15. The wireless power feeding system according to the present embodiment is the same as the above-described wireless power feeding system 1 according to the first embodiment except for a configuration of a power feeding coil 31. Therefore, common components are respectively denoted by the same reference numerals, and hence overlapping description is omitted.

An impedance matching mechanism 9 according to the present embodiment feeds power to at least one of three power feeding coils 31 (31I, 31J, and 31K) under switching control of switches 91e and 91f. If power can be selectively fed to any one of the power feeding coils 31I, 31J, and 31K, other components may be used instead of the switches 91e and 91f.

The power feeding coil 31 includes the three power feeding coils 31I, 31J, and 31K provided in parallel with one another. Each of respective coil axes 31i, 31j, and 31k of the power feeding coils 31I, 31J, and 31K and a coil axis 32a of a power transmission coil 32 are positioned substantially coaxially with each other in a normal state. Although a case where the power feeding coil 31 is divided into the three power feeding coil parts 31I, 31J, and 31K will be described below as an example, the number of the power feeding coils may be two or four or more.

The power feeding coils 31I, 31J, and 31K are arranged such that the power feeding coil 31I is closest to the power transmission coil 32 and such that they are spaced away from the power transmission coil 32 in this order. Therefore, coupling strengths in magnetic field coupling of the power feeding coil 31I and the power feeding coil 31K to the power transmission coil 32 are respectively set highest and lowest. When the power feeding coil 31 and the power transmission coil 32 are transmitted using a magnetic field resonance method, respective inductances of the power feeding coils 31I, 31J, and 31K are set equal to one another, thereby making it possible to efficiently transmit power.

Each of the switches 91e and 91f is a three-way switch for supplying a current to the power feeding coils 31I, 31J, and 31K. The switch 91e and one end side of each of the power feeding coils 31I, 31J, and 31K are connected to an AC power supply 5. The switch 91e is configured to be able to switch the other end side of the power feeding coil 31K and the switch 91f side. The switch 91f is configured to be able to switch the other end side of the power feeding coil 31I and the other end side of the power feeding coil 31J.

When power is fed to the power feeding coil 31I, the switch 91e is switched to the switch 91f side, and the switch 91f is switched to the other end side of the power feeding coil 31I. When power is fed to the power feeding coil 31J, the switch 91e is switched to the switch 91f side, and the switch 91f is switched to the other end side of the power feeding coil 31J. Further, when power is fed to the power feeding coil 31K, the switch 91e is switched to the power feeding coil 31K side.

When power is fed to any one of the power feeding coils 31I, 31J, and 31K, a coupling strength (coupling coefficient) between the power feeding coil 31 and the power transmission coil 32 can be adjusted depending on a distance from the power transmission coil 32. Accordingly, a load-side impedance as an impedance in a circuit on the load side from an input end IE of a power transmission device 3 can be adjusted.

Thus, the wireless power feeding system 1 according to the present embodiment is configured such that the power feeding coil 31 includes the plurality of power feeding coils 31I, 31J, and 31K are provided, are respectively set to differ in coupling strength in magnetic field coupling to the power transmission coil 32 and are connected in parallel with one another and the impedance matching mechanism 9 feeds power to at least one of the plurality of power feeding coils 31I, 31J, and 31K.

According to this configuration, when power is fed to any one of the power feeding coils 31I, 31J, and 31K that respectively differ in coupling strength in magnetic field coupling to the power transmission coil 32, an impedance of a circuit in the power transmission device 3 increases or decreases so that a difference between an input-side impedance and a load-side impedance is alleviated. Accordingly, a reflected wave is prevented from being generated at the input end IE, thereby making it possible to avoid a decrease in transmission efficiency and a system failure caused by a decrease in transmission power.

### <Third Embodiment>

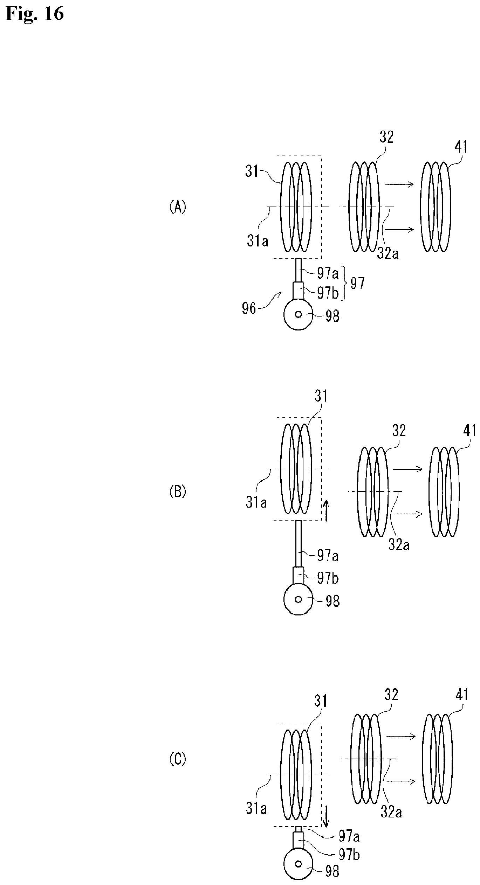

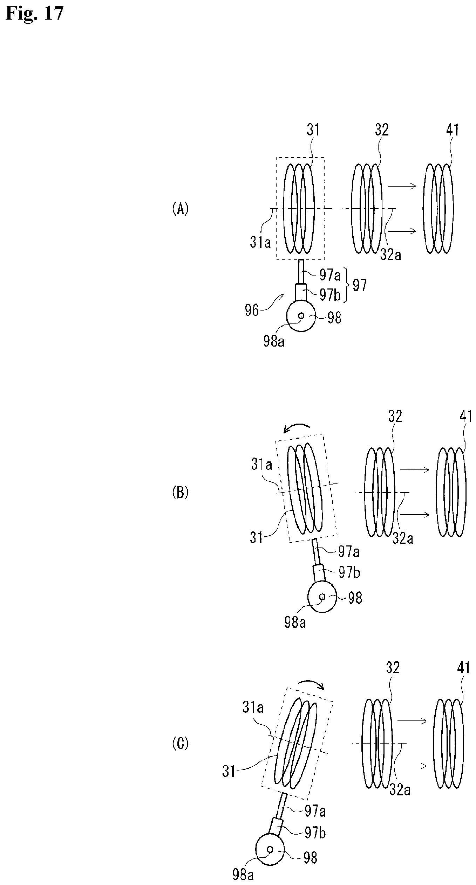

Then, a wireless power feeding system according to a third embodiment of the present invention will be described with reference to Figures 16 and 17. The wireless power feeding system according to the present embodiment is the same as the above-described wireless power feeding systems 1 according to the modification 1 and the modification 2 except for respective configurations of a power feeding coil 31 and a coil movement mechanism 96. Therefore, common components are respectively denoted by the same reference numerals, and hence overlapping description is omitted.

The coil movement mechanism 96 according to the present embodiment changes at least either one of a positional relationship and a posture of the power feeding coil 31 relative to a power transmission coil 32. The power feeding coil 31 is not configured such that power can be selectively fed to its portion, unlike the above-described power feeding coils 31 according to the embodiments and the modifications, but is configured to feed power to the entire power feeding coil 31.

The coil movement mechanism 96 includes a linear mechanism 97 and a swing mechanism 98. The linear mechanism 97 is a solenoid including a plunger 97a and a case 97b. The power feeding coil 31 is connected to a tip end of the plunger 97a. As illustrated in Figure 16, when the plunger 97a advances and retreats to and from a coil axis 31a of the power feeding coil 31 in a vertical direction, the coil axis 31a of the power feeding coil 31 and a coil axis 32a of the power transmission coil 32 move to separate from or come closer to(match) each other while the coil axis 31a and 32a are maintained in a substantially parallel state.

Specifically, when a position of the power feeding coil 31 at the time when the coil axis 31a of the power feeding coil 31 is positioned coaxially with the coil axis 32a of the power transmission coil 32 is set as an original position, as illustrated in Figure 16(a), the plunger 97a advances so that the power feeding coil 31 moves to separate from the original position in a direction perpendicular to the coil axis 31a, as illustrated in Figure 16(b), and the plunger 97a retreats so that the power feeding coil 31 moves to separate from the original position in the direction perpendicular to the coil axes 31a, as illustrated in Figure 16(c). Thus, the linear mechanism 91 changes a position of the power feeding coil 31 relative to the power transmission coil 32 such that the coil axis 31a of the power feeding coil 31 moves parallel to the coil axis 32a of the power transmission coil 32.

When the coil axis 31a of the power feeding coil 31 and the coil axis 32a of the power transmission coil 32 are coaxially positioned, a coupling strength in magnetic field coupling between the power feeding coil 31 and the power transmission coil 32 is high. Accordingly, an electromotive force to be generated in the power transmission coil 32 by a current flowing through the power feeding coil 31 increases. That is, an impedance in the power feeding coil 31 and the power transmission coil 32 decreases, and an impedance viewed from an input end IE is directly affected by an impedance on the downstream side (the load 8 side) of the power reception coil 41.

On the other hand, when the coil axis 31a of the power feeding coil 31 is offset in a direction perpendicular to the coil axis 31a with respect to the coil axis 32a of the power transmission coil 32, a coupling strength in magnetic field coupling between the power feeding coil 31 and the power transmission coil 32 is low. Accordingly, an electromotive force to be generated in the power transmission coil 32 by a current flowing through the power feeding coil 31 decreases. That is, an impedance in the power feeding coil 31 and the power transmission coil 32 increases, and an impedance viewed from the input end IE is not easily affected by an impedance on the downstream side (the load 8 side) of the power reception coil 41.

As a function of an offset amount between the coil axis 31a of the power feeding coil 31 and the coil axis 32a of the power transmission coil 32 (a stroke amount of the plunger 96a) and a change amount of an impedance of a circuit in a power transmission device 3, one previously obtained by an experiment or the like is used.

This makes it possible to implement a system in which the coil movement mechanism 96 changes a positional relationship or a posture of the power feeding coil 31 relative to the power transmission coil 32 to adjust a coupling strength (coupling coefficient) between the power feeding coil 31 and the power transmission coil 32 so that an influence of an impedance on the downstream side (the load 8 side) of the power reception coil 41 can be controlled and an impedance viewed from the input end IE is not easily subjected to an impedance change due to an operating situation of the load 8.

Specifically, when power of the load 8 is high and an impedance of the load 8 is low, a load-side impedance viewed from the input end IE of the power feeding coil 31 is also low, while an input-side impedance does not vary. Therefore, the load-side impedance needs to be high to match or come closer to the input-side impedance. In this case, the coil movement mechanism 96 moves the power feeding coil 31 in a direction perpendicular to the coil axis 31a while maintaining the coil axis 31a of the power feeding coil 31 and the coil axis 32a of the power transmission coil 32 in a substantially parallel state. As a result, an impedance in the power feeding coil 31 and the power transmission coil 32 increases, whereby the load-side impedance can be increased. At this time, when the load-side impedance is controlled to an impedance substantially equal to the input-side impedance, power reflection is suppressed, thereby making it possible to implement an efficient system driving situation.

On the other hand, when power of the load 8 is low and an impedance of the load 8 is high, a load-side impedance viewed from the input end IE of the power feeding coil 31 is also high, while an input-side impedance does not vary. Therefore, the load-side impedance needs to be low to match or come closer to the input-side impedance. In this case, the coil movement mechanism 96 moves the power feeding coil 31 such that the coil axis 31a of the power feeding coil 31 and the coil axis 32a of the power transmission coil 32 are coaxially positioned. As a result, an impedance in the power feeding coil 31 and the power transmission coil 32 decreases, whereby the load-side impedance can be decreased. At this time, when the load-side impedance is controlled to an impedance substantially equal to the input-side impedance, power reflection is suppressed, thereby making it possible to implement an efficient system driving situation.

In the coil movement mechanism 96, the swing mechanism 98 may swing the power feeding coil 31 on the basis of a function of respective inclinations of the coil axis 31a of the power feeding coil 31 and the coil axis 32a of the power transmission coil 32 and a distance between the power feeding coil 31 and the power transmission coil 32 and a change amount of the impedance of the circuit in the power transmission device 3, which has been previously obtained by an experiment or the like, instead of displacing the power feeding coil 31 in a direction perpendicular to a coil axial direction.

As illustrated in Figure 17, the swing mechanism 98 supports the case 97b and swings the case 97b around a rotation axis 98a.

Specifically, when a position of the plunger 97a at the time when the plunger 97a is perpendicular to the coil axis 31a of the power feeding coil 31 is set as an original position, as illustrated in Figure 17(a), the swing mechanism 98 separates the power feeding coil 31 positioned at the original position from the power transmission coil 32 while inclining the power feeding coil 31, as illustrated in Figure 17(a), and the swing mechanism 98 brings the power feeding coil 31 positioned at the original position closer to the power transmission coil 32 while inclining the power feeding coil 31, as illustrated in Figure 17(c). Thus, the swing mechanism 98 moves the power feeding coil 31 away from and nearer to the power transmission coil 32 while inclining the coil axis 31a of the power feeding coil 31 with respect to the coil axis 32a of the power transmission coil 32. At this time, if the power feeding coil 31 is a mechanism in which its center point is inclined toward its center, far-near movement of the power feeding coil 31 relative to the power transmission coil 32 does not occur, thereby making it possible to also perform control in only the inclination of the power feeding coil 31.

When a rotation angle of the plunger 97a in a case where the power feeding coil 31 swings to separate from the power transmission coil 32, as illustrated in Figure 17(b), is negative (-), and a rotation angle of the plunger 97a in a case where the power feeding coil 31 swings to come closer to the power transmission coil 32, as illustrated in Figure 17(c), is positive (+), a rotation range of the swing mechanism 98 is preferably set to ± 30 degrees around the original position of the plunger 97a, for example.

In a state where the DC-DC converter 7 is idling, the swing mechanism 98 swings the power feeding coil 31, whereby the coil axis 31a of the power feeding coil 31 comes closer in parallel with the coil axis 32a of the power transmission coil 32 and the power feeding coil 31 comes closer to the power transmission coil 32, as illustrated in Figures 17(b) and 17(c). Accordingly, a coupling strength in magnetic field coupling between the power feeding coil 31 and the power transmission coil 32 increases, and the impedance of the circuit in the power transmission device 3 decreases. Therefore, a difference between the input-side impedance and the load-side impedance at the input end IE is alleviated.

On the other hand, in a state where the DC-DC converter 7 is operating, the swing mechanism 98 swings the power feeding coil 31, whereby the coil axis 31a of the power feeding coil 31 is inclined with respect to the coil axis 32a of the power transmission coil 32 and the power feeding coil 31 separates from the power transmission coil 32. Accordingly, a coupling strength in magnetic field coupling between the power feeding coil 31 and the power transmission coil 32 decreases, and the impedance of the circuit in the power transmission device 3 increases. Therefore, a difference between the input-side impedance and the load-side impedance at the input end IE is alleviated.

Thus, the wireless power feeding system 1 according to the present embodiment is configured such that an impedance matching mechanism is the coil movement mechanism 96 that changes at least either one of a position and a posture of the power feeding coil 31 relative to the power transmission coil 32.

According to this configuration, a coupling strength in magnetic field coupling between the power feeding coil 31 and the power transmission coil 32 is adjusted depending on a position or a posture of the power feeding coil 31 relative to the power transmission coil 32, whereby an impedance of the circuit in the power transmission device 3 increases or decreases, and a difference between an input-side impedance and a load-side impedance viewed from the input end IE is alleviated. Accordingly, a reflected wave is prevented from being generated at the input end IE, thereby making it possible to avoid a decrease in transmission efficiency and a system failure caused by a decrease in transmission power.

The wireless power feeding system 1 according to the present embodiment further includes the DC-DC converter 7 that converts an output voltage of the power reception device 4 into a predetermined voltage, and is configured such that the coil movement mechanism 96 changes movement or a posture of the power feeding coil 31 relative to the power transmission coil 32 depending on an operating state of the DC-DC converter 7.

According to this configuration, even when a load-side impedance rapidly increases or rapidly decreases as the DC-DC converter 7 is turned on or off, a coupling strength in magnetic field coupling between the power feeding coil 31 and the power transmission coil 32 is adjusted depending on a position or a posture of the power feeding coil 31 relative to the power transmission coil 32, whereby an impedance of the circuit in the power transmission device 3 increases or decreases, and a difference between an input-side impedance and the load-side impedance at the input end IE is alleviated. Accordingly, a reflected wave is prevented from being generated at the input end IE, thereby making it possible to avoid a decrease in transmission efficiency and a system failure caused by a decrease in transmission power.

Although the coil movement mechanism 96 that changes a position or a posture of the power feeding coil 31 relative to the power transmission coil 32 has been described as an example in the present embodiment, a configuration of the coil movement mechanism 96 is not limited to this if a mechanism capable of changing a positional relationship between the power feeding coil 31 and the power transmission coil 32.

For example, the coil movement mechanism 96 may move the power feeding coil 31 by only either one of an advance or retreat operation of the linear mechanism 97 and a swing operation of the swing mechanism 98 or combining the advance or retreat operation of the linear mechanism 97 and the swing operation of the swing mechanism 98, or may slide the power feeding coil 31 in a coil axial direction such that the power feeding coil 31 moves the power feeding coil 31 farther from or nearer to the power transmission coil 32 instead of the linear mechanism 97 and the swing mechanism 98.

When the power reception coil 41 is fixed to a predetermined position, the coil movement mechanism 96 may be configured to change respective relative positions of the power transmission coil 32 and the power reception coil 41. As a result, a coupling strength in magnetic field coupling between the power feeding coil 31 and the power transmission coil 32 is adjusted (magnetic induction coupling between the power feeding coil 31 and the power transmission coil 32 becomes loose or tight), and an impedance of the circuit in the power transmission device 3 increases or decreases. Accordingly, a difference between an input-side impedance and a load-side impedance at the input end IE is alleviated.

The coil movement mechanism 96 may be configured to change respective relative positions of the power transmission coil 32 and the power reception coil 41 such that an impedance of the power transmission-side resonance circuit 36 matches an impedance of the power reception-side resonance circuit 43 depending on a positional relationship between the power transmission coil 32 and the power reception coil 41.

Although a variation of a load current occurring as the DC-DC converter 7 is turned on or off has been described as an example as a factor causing a load-side impedance to vary in the above-described embodiment, the factor causing the load-side impedance to vary is not limited to this.

For example, the load-side impedance may vary depending on movement of the power feeding target 2. The reason for this is that a coupling strength in magnetic field coupling between the power transmission coil 32 and the power reception coil 41 increases when the power reception coil 41 comes closer to the power transmission coil 32 and a coupling strength in magnetic field coupling between the power transmission coil 32 and the power reception coil 41 decreases when the power reception coil 41 separates from the power transmission coil 32 so that a coupling state of magnetic coupling between the power transmission coil 32 and the power reception coil 41 varies. Therefore, in such a case, a distance between the power transmission coil 32 and the power reception coil 41 may be monitored to determine to which of the power feeding coil parts 31A, 31B, and 31C power is fed such that an input-side impedance and a load-side impedance match each other depending on a change of a distance between the power transmission coil 32 and the power reception coil 41.

In each of the above-described embodiments, a case where all the power feeding coil 31, the power transmission coil 32, and the power reception coil 41 are each in a resonance state to make an imaginary part of an impedance zero to prevent reactive power from being generated has been described as an example. However, even when the capacitor 33 is not connected to the power feeding coil 31, for example, reactive power is generated in an input impedance, while power transmission itself is possible. Accordingly, only the power transmission coil 32 and the power reception coil 41 may be each in a resonance state.

Although the wireless power feeding system 1 has been described using a configuration of a three coil system including the power feeding coil 31, the power transmission coil 32, and the power reception coil 41 as an example in each of the above-described embodiments, the wireless power feeding system 1 may be a wireless power feeding system as a two coil system not having a power feeding coil 31 but having only a power transmission coil 32 and a power reception coil 41. In this case, when the power transmission coil 32 is divided into a plurality of power transmission coil parts and is configured to change respective relative positions of each of the power transmission coil parts and the power reception coil 41, thereby making it possible to control a load-side impedance.

In the two coil system including the power transmission coil 32 and the power reception coil 41, when a position of the power transmission coil 32 is moved to vary the load-side impedance, a coil axis 32a of the power transmission coil 32 and a coil axis of the power reception coil 41 are not coaxially positioned so that power transmission efficiency may decrease. On the other hand, in the three coil system including the power feeding coil 31, the power transmission coil 32, and the power reception coil 41, power is transmitted to the power transmission coil 32 via the power feeding coil 31, whereby a coupling strength in magnetic field coupling between the power feeding coil 31 and the power transmission coil 32 is adjusted without changing a positional relationship between the power transmission coil 32 and the power reception coil 41, thereby making it possible to control a load-side impedance and making it possible to maintain good power transmission efficiency.

Although the wireless power feeding system 1 has been described using the configuration of the three coil system including the power feeding coil 31, the power transmission coil 32, and the power reception coil 41 as an example in each of the above-described embodiments, a configuration of a wireless power feeding system using a four coil system including a second power reception coil in addition to a power reception coil 41 may be used. In this case, the power reception coil 41 is set to have a resonance frequency substantially equal to that of a power transmission coil 32, and power is transmitted using a magnetic field resonance method. The power reception coil 41 and the second power reception coil are arranged in a no-contact manner, and power is transmitted using an electromagnetic coupling (electromagnetic induction) method or a magnetic field resonance method. In the four coil system, the power transmission coil 32 and the power reception coil 41 are each a coil for resonance independent of another electrical circuit. Accordingly, the four coil system is easily designed because the resonance frequency does not change during driving, and a power transmission distance can be lengthened.

In the present invention, it should be understood that various modifications can be made in addition to the foregoing without departing from the spirit of the prevent invention and the present invention covers such modifications.

Respective configurations, methods, shapes, numerical values, and the like of the above-described embodiments and modifications can be combined with one another without departing from the spirit of the present invention.

### Reference Signs List

1: wireless power feeding system
11: wireless power transmission system
2: power feeding target
3: power transmission device
31, 31I ~ 31K: power feeding coil
31A ~ 31H: power feeding coil part
31a ~ 31c: coil axis (of power feeding coil)
32: power transmission coil
32a: coil axis (of power transmission coil)
33, 34: capacitor
35: power feeding-side resonance circuit
36: power transmission-side resonance circuit
4: power reception device
41: power reception coil
42: capacitor
43: power reception-side resonance circuit
5: AC power supply (power supply device)
6: rectifying circuit
61: diode
62: capacitor
7: DC-DC converter (voltage conversion circuit)
8: load
9: impedance matching mechanism
91a ~ 91d: switch
92: controller
93: storage unit
94: control unit
95: measurement unit
96: coil movement mechanism
96a, 97a: plunger
96b, 97b: case
97: linear mechanism
98: swing mechanism
IE: input end

## Claims

1. A wireless power feeding system that transmits and receives power using magnetism, the wireless power feeding system comprising:
a power transmission device that includes a power transmission-side resonance circuit including a power transmission coil and at least one power feeding coil that is provided to be capable of magnetic field coupling to the power transmission coil and transmits power to be fed from its input end to the power transmission coil;
a power reception device that includes a power reception-side resonance circuit including a power reception coil and feeds power received by the power reception coil to a load; and
an impedance matching mechanism that performs impedance matching processing for alleviating a difference between a load-side impedance as an impedance of a circuit on a load side from the input end of the power transmission device and an input-side impedance as an impedance of a circuit on a power supply device side from the input end of the power transmission device by changing a coupling strength in magnetic field coupling between the power feeding coil and the power transmission coil.

2. The wireless power feeding system according to claim 1, wherein
the power feeding coil is divided into a plurality of power feeding coil parts set to differ from one another in coupling strength in magnetic field coupling to the power transmission coil and is configured to be able to feed power to at least any one of the plurality of power feeding coil parts, and
the impedance matching mechanism feeds power to at least one of the plurality of power feeding coil parts.

3. The wireless power feeding system according to claim 2, wherein the plurality of power feeding coil parts respectively include coil axes arranged substantially coaxially with one another and are respectively set to differ in distances from the power transmission coil.

4. The wireless power feeding system according to claim 2, wherein the plurality of power feeding coil parts respectively include coil axes set in different directions and having different angles to a coil axis of the power transmission coil.

5. The wireless power feeding system according to claim 2, wherein the plurality of power feeding coil parts respectively include coil axes substantially parallel to the coil axis of the power transmission coil and offset from one another by different distances.

6. The wireless power feeding system according to claim 2, wherein
the plurality of power feeding coil parts respectively include coil axes arranged substantially coaxially with one another, and
respective coil diameters and coil heights of the power feeding coil parts are each set to differ from one another.

7. The wireless power feeding system according to claim 2, wherein the power feeding coil parts are configured to be movable relative to the power transmission coil.

8. The wireless power feeding system according to claim 2, wherein
power is fed from the power feeding coil to the power transmission coil using a magnetic field resonance method, and
respective inductance values of the power feeding coil parts are set substantially equal to one another.

9. The wireless power feeding system according to claim 1, wherein
a plurality of the power feeding coils are provided, are respectively set to differ in coupling strength in magnetic field coupling to the power transmission coil and are connected in parallel with one another, and
the impedance matching mechanism feeds power to at least one of the plurality of power feeding coils.

10. The wireless power feeding system according to claim 9, wherein the plurality of power feeding coils respectively include coil axes arranged substantially coaxially with one another and are respectively set to differ in distances from the power transmission coil.

11. The wireless power feeding system according to claim 9, wherein the plurality of power feeding coils respectively include coil axes set in different directions and having different angles to the coil axis of the power transmission coil.

12. The wireless power feeding system according to claim 9, wherein the plurality of power feeding coils respectively include coil axes substantially parallel to the coil axis of the power transmission coil and offset from one another by different distances.

13. The wireless power feeding system according to claim 9, wherein
the plurality of power feeding coils respectively include coil axes arranged substantially coaxially with one another, and
respective coil diameters and coil heights of the power feeding coils are each set to differ from one another.

14. The wireless power feeding system according to claim 9, wherein the power feeding coils are configured to be movable relative to the power transmission coil.

15. The wireless power feeding system according to claim 9, wherein power is fed from the power feeding coils to the power transmission coil using a magnetic field resonance method, and respective inductance values of the power feeding coils are set substantially equal to one another.

16. The wireless power feeding system according to claim 1, wherein the impedance matching mechanism is a coil movement mechanism that changes at least either one of a position and a posture of the power feeding coil relative to the power transmission coil.

17. The wireless power feeding system according to claim 1, further comprising
a measurement unit that measures a load current to be fed to the load or a load voltage to be applied to the load, and
the impedance matching mechanism performs impedance matching processing depending on a measurement result of the measurement unit.

18. The wireless power feeding system according to claim 1, wherein
the power reception device includes a voltage conversion circuit that converts an output voltage of the power reception device into a predetermined voltage, and
the impedance matching mechanism moves the power feeding coil relative to the power transmission coil depending on an operating state of the voltage conversion circuit.

19. The wireless power feeding system according to claim 1, wherein power is fed from the power transmission coil to the power reception coil using a magnetic field resonance method.

20. A wireless power feeding method using a wireless power feeding system that transmits and receives power using magnetism and comprises
a power transmission device that includes a power transmission-side resonance circuit including a power transmission coil and a power feeding coil that is provided to be capable of magnetic field coupling to the power transmission coil and transmits power to be fed from its input end to the power transmission coil, and
a power reception device that includes a power reception-side resonance circuit including a power reception coil and feeds power received by the power reception coil to a load,
the wireless power feeding method comprising:
alleviating a difference between a load-side impedance as an impedance of a circuit on a load side from the input end of the power transmission device and an input-side impedance as an impedance of a circuit on a power supply device side from the input end of the power transmission device by changing a coupling strength in magnetic field coupling between the power feeding coil and the power transmission coil using an impedance matching mechanism.

21. A wireless power transmission system that transmits power to a power reception device using magnetism, the wireless power transmission system comprising:
a power transmission device that includes a power transmission-side resonance circuit including a power transmission coil and a power feeding coil that is provided to be capable of magnetic field coupling to the power transmission coil and transmits power to be fed from its input end to the power transmission coil and that transmits the power to a load via the power reception device; and
an impedance matching mechanism that performs impedance matching processing for alleviating a difference between a load-side impedance as an impedance of a circuit on a load side from the input end of the power transmission device and an input-side impedance as an impedance of a circuit on a power supply device side from the input end of the power transmission device by changing a coupling strength in magnetic field coupling between the power feeding coil and the power transmission coil.

## Amended claims

### Amended claims under Art. 19.1 PCT

1. (Amended) A wireless power feeding system that transmits and receives power using magnetism, the wireless power feeding system comprising:
a power transmission device that includes a power transmission-side resonance circuit including a power transmission coil and at least one power feeding coil that is provided to be capable of magnetic field coupling to the power transmission coil and transmits power to be fed from its input end to the power transmission coil using a magnetic field resonance method;
a power reception device that includes a power reception-side resonance circuit including a power reception coil and feeds power received by the power reception coil to a load; and
an impedance matching mechanism that performs impedance matching processing by changing a coupling strength in magnetic field coupling between the power feeding coil and the power transmission coil with inductance values of the power feeding coil substantially equal to one another depending on a variation of a load-side impedance as an impedance of a circuit on a load side from the input end of the power transmission device to alleviate a difference between the load-side impedance and an input-side impedance as an impedance of a circuit on a power supply device side from the input end of the power transmission device.

2. The wireless power feeding system according to claim 1, wherein
the power feeding coil is divided into a plurality of power feeding coil parts set to differ from one another in coupling strength in magnetic field coupling to the power transmission coil and is configured to be able to feed power to at least any one of the plurality of power feeding coil parts, and
the impedance matching mechanism feeds power to at least one of the plurality of power feeding coil parts.

3. The wireless power feeding system according to claim 2, wherein the plurality of power feeding coil parts respectively include coil axes arranged substantially coaxially with one another and are respectively set to differ in distances from the power transmission coil.

4. The wireless power feeding system according to claim 2, wherein the plurality of power feeding coil parts respectively include coil axes set in different directions and having different angles to a coil axis of the power transmission coil.

5. The wireless power feeding system according to claim 2, wherein the plurality of power feeding coil parts respectively include coil axes substantially parallel to the coil axis of the power transmission coil and offset from one another by different distances.

6. The wireless power feeding system according to claim 2, wherein
the plurality of power feeding coil parts respectively include coil axes arranged substantially coaxially with one another, and
respective coil diameters and coil heights of the power feeding coil parts are each set to differ from one another.

7. (Deleted)

8. (Deleted)

9. The wireless power feeding system according to claim 1, wherein
a plurality of the power feeding coils are provided, are respectively set to differ in coupling strength in magnetic field coupling to the power transmission coil and are connected in parallel with one another, and
the impedance matching mechanism feeds power to at least one of the plurality of power feeding coils.

10. The wireless power feeding system according to claim 9, wherein the plurality of power feeding coils respectively include coil axes arranged substantially coaxially with one another and are respectively set to differ in distances from the power transmission coil.

11. The wireless power feeding system according to claim 9, wherein the plurality of power feeding coils respectively include coil axes set in different directions and having different angles to the coil axis of the power transmission coil.

12. The wireless power feeding system according to claim 9, wherein the plurality of power feeding coils respectively include coil axes substantially parallel to the coil axis of the power transmission coil and offset from one another by different distances.

13. The wireless power feeding system according to claim 9, wherein
the plurality of power feeding coils respectively include coil axes arranged substantially coaxially with one another, and
respective coil diameters and coil heights of the power feeding coils are each set to differ from one another.

14. (Deleted)

15. (Deleted)

16. The wireless power feeding system according to claim 1, wherein the impedance matching mechanism is a coil movement mechanism that changes at least either one of a position and a posture of the power feeding coil relative to the power transmission coil.

17. The wireless power feeding system according to claim 1, further comprising
a measurement unit that measures a load current to be fed to the load or a load voltage to be applied to the load, and
the impedance matching mechanism performs impedance matching processing depending on a measurement result of the measurement unit.

18. The wireless power feeding system according to claim 1, wherein
the power reception device includes a voltage conversion circuit that converts an output voltage of the power reception device into a predetermined voltage, and
the impedance matching mechanism moves the power feeding coil relative to the power transmission coil depending on an operating state of the voltage conversion circuit.

19. The wireless power feeding system according to claim 1, wherein power is fed from the power transmission coil to the power reception coil using a magnetic field resonance method.

20. (Amended) A wireless power feeding method using a wireless power feeding system that transmits and receives power using magnetism and comprises
a power transmission device that includes a power transmission-side resonance circuit including a power transmission coil and a power feeding coil that is provided to be capable of magnetic field coupling to the power transmission coil and transmits power to be fed from its input end to the power transmission coil using a magnetic field resonance method, and
a power reception device that includes a power reception-side resonance circuit including a power reception coil and feeds power received by the power reception coil to a load,
the wireless power feeding method comprising
changing a coupling strength in magnetic field coupling between the power feeding coil and the power transmission coil with inductance values of the power feeding coil substantially equal to one another depending on a variation of a load-side impedance as an impedance of a circuit on a load side from the input end of the power transmission device to alleviate a difference between the load-side impedance and an input-side impedance as an impedance of a circuit on a power supply device side from the input end of the power transmission device using an impedance matching mechanism.

21. (Amended) A wireless power transmission system that transmits power to a power reception device using magnetism, the wireless power transmission system comprising:
a power transmission device that includes a power transmission-side resonance circuit including a power transmission coil and a power feeding coil that is provided to be capable of magnetic field coupling to the power transmission coil and transmits power to be fed from its input end to the power transmission coil using a magnetic field resonance method and that transmits the power to a load via the power reception device; and
an impedance matching mechanism that performs impedance matching processing by changing a coupling strength in magnetic field coupling between the power feeding coil and the power transmission coil with inductance values of the power feeding coil substantially equal to one another depending on a variation of a load-side impedance as an impedance of a circuit on a load side from the input end of the power transmission device to alleviate a difference between the load-side impedance and an input-side impedance as an impedance of a circuit on a power supply device side from the input end of the power transmission device.

Statement under Art. 19.1 PCT
Claim 1 clarifies that an impedance matching mechanism changes a coupling strength in magnetic field coupling between a power feeding coil and a power transmission coil with inductance values of the power feeding coil substantially equal to one another. It is true of Claims 20 and 21

The phrase "with inductance values of the power feeding coil substantially equal to one another" in this amendment depends on description in paragraph [0031] of the specification (when the power feeding coil 31 and the power transmission coil 32 are transmitted using a magnetic field resonance method, respective inductances of the power feeding coil parts 31A, 31B, and 31C are set equal to one another) and description in paragraph [0129] (when the power feeding coil 31 and the power transmission coil 32 are transmitted using a magnetic field resonance method, respective inductances of the power feeding coils 31I, 31J, and 31K are set equal to one another), for example.
